# EUROPEAN PATENT APPLICATION

(11) **EP 2 804 223 A1**
(43) Date of publication of application: **19.11.2014**
(21) Application number: 13736248.9
(22) Date of filing: 10.01.2013
(51) Int. Cl.: H01L 31/042, B32B 27/00, C08L 23/08, C09K 3/10

(54) **SOLAR CELL MODULE HAVING EXCELLENT APPEARANCE AND METHOD FOR MANUFACTURING SAME**

(30) Priority: 13.01.2012 JP 2012005339; 13.01.2012 JP 2012005342
(71) Applicant: Mitsubishi Plastics, Inc., Tokyo 100-8252 (JP)
(72) Inventor: TANIGUCHI, Kouichirou, Nagahama-shi Shiga 526-8660 (JP); OTSUKA, Michiko, Nagahama-shi Shiga 526-8660 (JP); FUKUDA, Shinya, Nagahama-shi Shiga 526-8660 (JP); NISHIOKA, Jun, Nagahama-shi Shiga 526-8660 (JP); MIYASHITA, Yo, Nagahama-shi Shiga 526-8660 (JP)
(74) Representative: Hoffmann Eitle
(86) International application number: PCT/JP2013/050339
(87) International publication number: WO 2013/105616

(57) **Abstract**

Provided are a solar cell module produced by laminating at least a back sheet (A) and an encapsulant (B), in which the condition of the lamination can be easily set and which has a good appearance after lamination, and a method for producing such a solar cell module.

The solar cell module in which the ratio (σ(A)/G'(B)) of a shrinkage stress (σ(A)) (Pa) of the back sheet (A) and a shear elastic modulus (G'(B))(Pa) of the encapsulant (B) at a preset lamination temperature is 60.0 or less, wherein the shrinkage stress (σ(A)) of the back sheet (A) is a measured value (Pa) for the back sheet (A) at the preset lamination temperature, and the shear elastic modulus (G'(B)) of the encapsulant (B) is a measured value (Pa) for the encapsulant (B) at an oscillation frequency of 1Hz at the preset lamination temperature.

## Description

### [Technical Field]

The present invention relates to a solar cell module, and particularly to a solar cell module having good appearance, for which the laminate condition is easy to set, and to its production method.

### [Background Art]

Recently, with the increase in public awareness of environmental issues such as global warming and others, expectations for solar power generation have been much raised in view of the cleanness thereof and freeness from environmental pollution. A solar cell constitutes the main part of a solar power generation system which directly converts the energy of sunlight into electricity. Regarding the configuration of the solar cell, in general, multiple solar cell elements (cells) are connected in series or in parallel and are packaged variously for protecting the cells to give individual units. The unit installed in the package is referred to as a solar cell module, and, in general, this is so designed that the face thereof to be exposed to sunlight is covered with a transparent substrate as an upper protective material (glass or resin sheet - hereinafter this may be referred to as a front sheet), the space is filled up with an encapsulant (encapsulant resin layer) of a thermoplastic resin (for example, ethylene-vinyl acetate copolymer or polyethylene polymer), and the back face is protected with a back encapsulant sheet as a lower protective material (hereinafter this may be referred to as a back sheet).

Here the main ingredient of the encapsulant includes ethylene-vinyl acetate copolymer (hereinafter this may be referred to as EVA), polyethylene (hereinafter this may be referred to as PE), ionomer (hereinafter this may be referred to as IO), polyvinyl butyral (hereinafter this may be referred to as PVB), etc.

Further, the encapsulant is essentially required to satisfy softness and impact resistance for protecting solar cell elements, to satisfy heat resistance for protecting solar cell modules in heat generation, transparency (total light transmission, etc.) for efficient arrival of sunlight to solar cell elements, as well as durability, dimensional stability, flame retardance, water vapor barrier property, etc. Moreover, the encapsulant is used generally in lamination, and therefore the suitability thereof for lamination process and the appearance thereof after lamination are also important.

Here the lamination condition for solar cell modules may be set in many cases according to a trial-and-error method in consideration of various members to be used (encapsulant, back sheet, glass, wiring, cell, etc.), and therefore there are some problems in that the condition setting takes much time and the cost of the members to be used is high.

One concrete problem with the solar cell module's appearance in condition setting is a phenomenon that protruding projections form on the face of the back sheet (hereinafter this may be referred to as projection phenomenon). Regarding this problem, PTL 1 says that, in vacuum lamination in producing solar cell modules by the use of a back sheet (back protective sheet for solar cell module), the back sheet may shrink and the solar cell element and the lead wire (tag) that connects the elements may follow the back sheet shrinkage, whereby the lead wire may deform and the distance between the solar cell elements may vary to cause the problem. As a measure against the problem, the reference discloses that the thermal shrinkage rate of the back sheet at 150°C for 30 minutes is preferably at most 1.0%, more preferably at most 0.5%, even more preferably within a range of from 0.3% to 0.1%.

On the other hand, PTL 2 discloses that a biaxially-oriented PET film has a large thermal shrinkage rate and therefore has some risks of wire (corresponding to lead wire in PTL 1) bending or cell misalignment especially in a process of producing large-size solar cell modules, and that for solving the problem of film shrinkage to be caused by the thermal shrinkage rate, a thermal fixation step for annealing the oriented film is needed with respect to facilities, which brings about film cost increase, that is, there occurs another problem in point of cost in that inexpensive back sheets could not be obtained (see PTL 2, paragraph 0007). As the measure, the reference proposes a back sheet that comprises a laminate of a polycarbonate film and a gas-barrier transparent deposition film (see PTL 2, Claim 1).

### [Citation List]

### [Patent Literature]

[PTL 1] JP-A 2007-150084
[PTL 2] JP-A 2006-324556

### [Summary of Invention]

### [Technical Problem]

As disclosed in PTL 1 and PTL 2, the existing technology to overcome the projection phenomenon is only to turn their attention to the back sheet of the members to be used in producing solar cell modules. However, even though the back sheet that satisfies specific physical properties (for example, the thermal shrinkage characteristic) is used, the projection phenomenon could not always be overcome, and the load in the trial-and-error method in setting the lamination condition could not be so much reduced. From this situation, a new quantitative index that is hardly affected by the thermal shrinkage characteristic of the back sheet used and that makes it possible to efficiently set the lamination condition is desired.

An object of the present invention is to provide, with respect to a solar cell module, a solar cell module having a good appearance after lamination, a back sheet-encapsulant-integrated-sheet, and a method for producing such a solar cell module.

### [Solution to Problem]

As a result of assiduous studies made repeatedly, the present inventors have found that a solar cell module having a good appearance after lamination can be obtained by using a back sheet and an encapsulant in combination, which have a specific quantitative relationship at a preset lamination temperature which is any temperature preset in the lamination temperature range, to thereby have completed the present invention.

Specifically, the present invention relates to the following [1] to [18].
[1] A solar cell module containing at least a back sheet (A) and an encapsulant (B) laminated, wherein the ratio (σ(A)/G'(B)) of a shrinkage stress (σ(A))(Pa) of the back sheet (A) and a shear elastic modulus (G'(B))(Pa) of the encapsulant (B) at a preset lamination temperature is 60.0 or less,
   the shrinkage stress (σ(A)) of the back sheet (A) being a measured value (Pa) for the back sheet (A) at the preset lamination temperature; and
   the shear elastic modulus (G'(B))of the encapsulant (B) being a measured value (Pa) for the encapsulant (B) at an oscillation frequency of 1Hz at the preset lamination temperature.
[2] The solar cell module according to the above [1], wherein the ratio (σ(A)/G'(B))of the shrinkage stress (σ(A))(Pa) of the back sheet (A) and the shear elastic modulus (G'(B))(Pa) of the encapsulant (B) at the preset lamination temperature is 0.01 or more and 60.0 or less.
[3] The solar cell module according to the above [1], wherein the ratio (σ(A)/G'(B)) of the shrinkage stress (σ(A))(Pa) of the back sheet (A) and the shear elastic modulus (G'(B))(Pa) of the encapsulant (B) at the preset lamination temperature is 0.01 or more and 35.0 or less.
[4] The solar cell module according to the above [1], wherein the ratio (σ(A)/G'(B)) of the shrinkage stress (σ(A))(Pa) of the back sheet (A) and the shear elastic modulus (G'(B))(Pa) of the encapsulant (B) at the preset lamination temperature is 1.0 or more and 20.0 or less.
[5] The solar cell module according to any one of the above [1] to [4], wherein the storage elastic modulus (E') of the encapsulant (B) at an oscillation frequency of 10 Hz and at a temperature of 20°C is 1 to 100 MPa.
[6] The solar cell module according to any one of the above [1] to [5], wherein the encapsulant (B) is an encapsulant containing, as a main ingredient, a copolymer of ethylene and an α-olefin having 3 to 20 carbon atoms.
[7] The solar cell module according to any one of the above [1] to [6], wherein the encapsulant (B) is used on the inner side of the back sheet (A).
[8] The solar cell module according to the above [7], wherein the encapsulant (B) further satisfies the following Requirement (P):
   Requirement (P); a resin composition to constitute the encapsulant (B) contains an olefin-based polymer (X) having an MFR (JIS K7210, temperature: 190°C, load: 21.18 N) of less than 5 g/10 min and an olefin-based polymer (Y) having an MFR (JIS K7210, temperature: 190°C, load: 21.18 N) of 5 g/10 min or more.
[9] The solar cell module according to the above [8], wherein the mixing ratio by mass of the olefin-based polymer (X) and the olefin-based polymer (Y) contained in the resin composition to constitute the encapsulant (B) is (95 to 55)/(5 to 45).
[10] The solar cell module according to the above [8] or [9], wherein the MFR (JIS K7210, temperature: 190°C, load: 21.18 N) of the olefin-based polymer (X) contained in the resin composition to constitute the encapsulant (B) is 0.5 g/10 min or more and less than 5 g/10 min, and the MFR (JIS K7210, temperature: 190°C, load: 21.18 N) of the olefin-based polymer (Y) is 5 g/10 min or more and 100 g/10 min or less.
[11] The solar cell module according to any one of the above [1] to [10], wherein the encapsulant (B) has a laminate configuration that comprises at least a soft layer of which the storage elastic modulus (E') in dynamic viscoelastometry at an oscillation frequency of 10 Hz and at a temperature of 20°C is less than 100 MPa, and a hard layer of which the storage elastic modulus (E') in dynamic viscoelastometry at an oscillation frequency of 10 Hz and at a temperature of 20°C is 100 MPa or more.
[12] The solar cell module according to any one of the above [1] to [11], wherein the encapsulant (B) is an encapsulant that is not substantially crosslinked.
[13] The solar cell module according to any one of the above [1] to [12], wherein the shrinkage stress (σ(A)) of the back sheet (A) is 7 x 10⁵ Pa or less at 130°C and at 150°C.
[14] The solar cell module according to any one of the above [1] to [12], wherein the shrinkage stress (σ(A)) of the back sheet (A) is 4 × 10⁵ Pa or less at 130°C and at 150°C.
[15] The solar cell module according to any one of the above [1] to [14], wherein the back sheet (A) and the encapsulant (B) are integrated together.
[16] A method for manufacturing the solar cell module
   according to any one of the above [1] to [15], wherein the preset lamination temperature is 100°C or higher and 135°C or lower.
[17] A back sheet-encapsulant-integrated-sheet for a solar cell module, containing at least a back sheet (A) and an encapsulant (B), wherein the ratio (σ(A)/G'(B)) of a shrinkage stress (σ(A))(Pa) of the back sheet (A) and a shear elastic modulus (G'(B))(Pa) of the encapsulant (B) at a preset lamination temperature is 60.0 or less,
   the shrinkage stress (σ(A)) of the back sheet (A) being a measured value (Pa) for the back sheet (A) at the preset lamination temperature; and
   the shear elastic modulus (G' (B))of the encapsulant (B) being a measured value (Pa) for the encapsulant (B) at an oscillation frequency of 1Hz at the preset lamination temperature.
[18] The back sheet-encapsulant-integrated-sheet for a solar cell module according to the above [17], wherein the encapsulant (B) satisfies the following Requirement (P):

Requirement (P); a resin composition to constitute the encapsulant (B) contains an olefin-based polymer (X) having an MFR (JIS K7210, temperature: 190°C, load: 21.18 N) of less than 5 g/10 min and an olefin-based polymer (Y) having an MFR (JIS K7210, temperature: 190°C, load: 21.18 N) of 5 g/10 min or more.

### [Advantageous Effects of Invention]

According to the present invention, with respect to a solar cell module, there can be provided a solar cell module having a good appearance after lamination, a back sheet-encapsulant-integrated-sheet, and a method for producing the solar cell module.

In addition, by measuring basic physical properties, such as shrinkage stress of the back sheet and shear elastic modulus of the encapsulant at the preset lamination temperature, it becomes possible to predict the final appearance prior to actual lamination of solar cell modules. Further, since the lamination condition can be set efficiently, the time to be taken for condition investigation and the cost of various members can be saved and, as a result, the production cost of solar cell module can be expected to be greatly reduced.

### [Brief Description of Drawing]

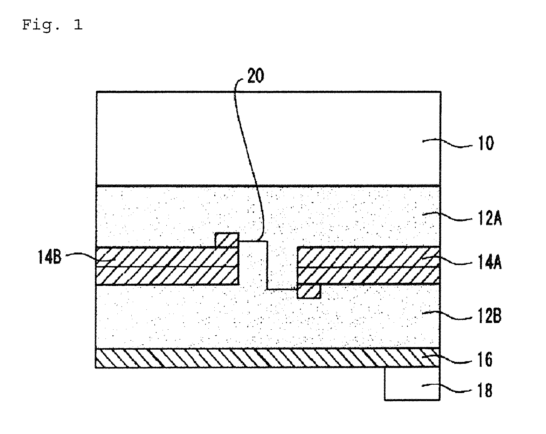

[Fig. 1] This is a schematic cross-sectional view showing one example of the solar cell module of the present invention.

### [Description of Embodiments]

Embodiments of the solar cell module of the present invention are described below. However, the scope of the present invention is not limited to the embodiments described below.

In the present specification, "comprising as a main ingredient" is a phrase to the effect that the composition may contain any other ingredient within a range not detracting from the effect and the advantage of the resin that constitutes the individual members of the solar cell module of the present invention. Further, though the phrase is not to restrict any concrete content, the main ingredient is an ingredient that accounts for generally 50% by mass or more of all the constituent ingredients of the resin composition, preferably 65% by mass or more, more preferably 80% by mass or more and 100% by mass or less.

The present invention is described in detail hereinunder.

In the solar cell module of the present invention, the ratio (σ(A)/G'(B)) (hereinafter, sometimes referred to as projection index) of a shrinkage stress (σ(A))(Pa) of a back sheet (A) and a shear elastic modulus (G'(B))(Pa) of an encapsulant (B) at a preset lamination temperature falls within a specific range.

In the above description, the solar cell module generally has the back sheet (A), the encapsulant (B), solar cell elements, and a transparent substrate (an upper protective material).

### [Back sheet (A)]

The back sheet (A) for use in the present invention is not specifically defined as long as it satisfies the projection index described later. Concretely, a substrate sheet (or a substrate film) of the back sheet is formed of an electrically-insulating material such as a polyester resin (polyethylene terephthalate (PET), polyethylene naphthalate (PEN), etc.), a fluororesin (polytetrafluoroethylene (PTFE), tetrafluoroethylene-perfluoroalkyl vinyl ether copolymer (PFA), tetrafluoroethylene-hexafluoropropylene copolymer (FEP), ethylene-tetrafluoroethylene copolymer (ETFE), polychlorotrifluoroethylene (PCTFE), polyvinylidene fluoride (PVDF), polyvinyl fluoride (PVF), etc.), a polyolefin resin (polyethylene (PE), polypropylene (PP), various α-olefin copolymers, ethylene-vinyl acetate copolymer (EVA), ethylene-ethyl acrylate copolymer (EEA), ethylene-acrylic acid copolymer (EAA), ethylene-methacrylic acid copolymer (EMAA), etc.), a cyclic olefin resin (COP, COC, etc.), a polystyrene resin (acrylonitrile-styrene copolymer (AS), acrylonitrile-butadiene-styrene copolymer (ABS), acrylonitrile-styrene-acrylic rubber copolymer (ASA), syndiotactic polystyrene (SPS), etc.), polyamide (PA), polycarbonate (PC), polymethyl methacrylate (PMMA), modified polyphenylene ether (modified PPE), polyphenylene sulfide (PPS), polyether sulfone (PES), polyphenyl sulfone (PPSU), polyether ether ketone (PEEK), polyether imide (PEI), polyimide (PI), and a biopolymer (polylactic acid, isosorbide polymer, polyamide polymer, polyester polymer, polyolefin polymer, etc.), etc.

In the present invention, polyester resin, polyolefin resin and fluororesin are preferred as the material for the substrate sheet, from the viewpoint of the adhesiveness to encapsulant, the mechanical strength, the durability and the economic efficiency thereof.

The production method for the substrate sheet or the substrate film is not specifically defined. Typically there are mentioned an extrusion casting method, a stretching method, an inflation method, a casting method, etc. For improving the handleability, the durability and the light reflectivity thereof and from the viewpoint of the economic efficiency of the substrate sheet, any other resin and various additives may be added to the sheet, if desired. The additives include, for example, an antioxidant, a UV absorbent, a weather-resistant stabilizer, a light diffusing agent, a nucleating agent, a pigment (for example, titanium oxide, barium sulfate, carbon black, etc.), a flame retardant, a discoloration inhibitor, a hydrolysis inhibitor, a heat-releasing agent, etc.

Further, if desired, the surface and/or the back of the substrate sheet may be embossed or may be processed variously (through corona treatment, plasma treatment, etc.) or may be coated (fluororesin coating, hydrolysis-resistant coating, hard coating, etc.), for improving the handleability, the adhesiveness and the durability of the sheet.

The back sheet (A) for use in the present invention may have a single-layer or laminate configuration, but preferably has a laminate structure for attaining the necessary characteristics for the back sheet in a well-balanced manner.

The characteristics that are generally necessary for back sheet include adhesiveness to encapsulant, mechanical strength, durability (weather resistance, hydrolysis resistance, etc.), light reflectivity, water vapor barrier property, flame retardance, design performance, economic efficiency, appearance after lamination, etc. Above all, in the case of crystal silicon-based solar cell modules, adhesiveness to encapsulant, mechanical strength, durability, economic efficiency and appearance after lamination are considered to be specifically important for the back sheet.

For attaining these characteristics in a well-balanced manner, laminate configurations mentioned below are preferred for the back sheet (A) for use in the present invention. In this specification, the expression of A/B/C means that the layers are laminated in the order of A, B and C from the top (or from the bottom).
(1) Fluororesin layer/adhesive layer/polyester resin layer/adhesive layer/adhesion-improving layer (encapsulant side); concretely, PVF/adhesive layer/biaxially-oriented PET/adhesive layer/EVA, PVF/adhesive layer/biaxially-oriented PET/adhesive layer/PE, PVF/adhesive layer/biaxially-oriented PET/adhesive layer/PP, ETFE/adhesive layer/biaxially-oriented PET/adhesive layer/EVA, ETFE/adhesive layer/biaxially-oriented PET/adhesive layer/PE, ETFE/adhesive layer/biaxially-oriented PET/adhesive layer/PP, etc.
(2) Polyester resin layer/adhesive layer/polyester resin layer/adhesive layer/adhesion-improving layer (encapsulant side); concretely biaxially-oriented PET (processed for resistance to hydrolysis)/adhesive layer/biaxially-oriented PET/adhesive layer/EVA, biaxially-oriented PET (processed for resistance to hydrolysis)/adhesive layer/biaxially-=oriented PET/adhesive layer/PE, biaxially-oriented PET (processed for resistance to hydrolysis)/adhesive layer/biaxially-=oriented PET/adhesive layer/PP, (surface-coated) biaxially-oriented PET/adhesive layer/biaxially-oriented PET/adhesive layer/adhesion-improving layer, etc.
(3) Polyester resin layer/adhesive layer/adhesion-improving layer (encapsulant side); concretely, biaxially-oriented PET (processed for resistance to hydrolysis)/adhesive layer/EVA, biaxially-=oriented PET (processed for resistance to hydrolysis)/adhesive layer/PE, biaxially-oriented PET (processed for resistance to hydrolysis)/adhesive layer/PP, (surface-coated) biaxially-oriented PET/adhesive layer/adhesion-improving layer, etc.

In the above (1) to (3), the adhesive layer is an optional element which is arranged, if desired, and the adhesive layer may be omitted. In case where the water vapor barrier property is considered to be specifically important for the sheet, for example, the above-mentioned configuration of the sheet, biaxially-oriented PET (processed for resistance to hydrolysis)/adhesive layer/biaxially-oriented PET/adhesive layer/PE may be modified to biaxially-oriented PET (processed for resistance to hydrolysis)/adhesive layer/vapor-deposition layer (SiOx, alumina, etc.)/biaxially-oriented PET/adhesive layer/ biaxially-oriented PET)/adhesive layer/PE, etc.

The crystal melting peak temperature (Tm) of the adhesion-improving layer is generally 80°C or higher and 165°C or lower. In the present invention, the lower limit of the crystal melting peak temperature (Tm) of the adhesion-improving layer is preferably 95°C or higher, more preferably 100°C or higher, from the viewpoint of the adhesiveness to the encapsulant (B), the economic efficiency, and the appearance of solar cell modules. On the other hand, the upper limit is preferably 140°C or lower, more preferably 125°C or lower.

The total thickness of the back sheet (A) for use in the present invention is not specifically defined as long as it satisfies the projection index described later. The total thickness may be suitably selected in consideration of the desired performance thereof. Typically the total thickness could be 50 µm or more and 600 µm or less, preferably 150 µm or more and 400 µm or less. For satisfying the dielectric breakdown voltage of 1 kV or more, the total thickness is preferably 200 µm or more, more preferably 250 µm or more.

### [Encapsulant (B)]

The encapsulant (B) for use in the present invention is not specifically defined as long as it satisfies the projection index described later, and may be used in any position, such as on the back sheet side and on the front sheet side. Concretely, there are mentioned encapsulants comprising, as the main ingredient thereof, ethylene-vinyl acetate copolymer (EVA), polyethylene (PE), polypropylene (PP), ionomer (IO), polyvinyl butyral (PVB) or the like. Preferred for use in the present invention are encapsulants comprising, as the main ingredient thereof, an olefin-based polymer represented by each of the following (B-1) to (B-4). Here as the main ingredient, preferred are those of (B-1) or (B-2), from the viewpoint of the softness of the encapsulants to be obtained, the absence of fish eyes (gels), the absence of circuit-corrosive substances (acetic acid, etc.), the economic efficiency and others; and especially preferred are those of (B-1) from the viewpoint that they are excellent in low-temperature characteristics.

### (B-1)

(B-1) is a copolymer of ethylene and an α-olefin having from 3 to 20 carbon atoms. Here, examples of the α-olefin to copolymerize with ethylene include propylene, 1-butene, 1-pentene, 1-hexene, 1-heptene, 1-octene, 1-nonene, 1-decene, 3-methyl-butene-1, 4-methyl-pentene-1, etc.

In the present invention, from the viewpoint of the industrial availability and various characteristics thereof and also from the economic efficiency thereof, propylene, 1-butene, 1-hexene and 1-octene are preferred as the α-olefin to copolymerize with ethylene. Further from the viewpoint of the transparency and the softness thereof, an ethylene-α-olefin random copolymer is preferred for use herein. The α-olefins capable of copolymerizing with ethylene may be used alone or in combination of two or more thereof.

The content of the α-olefin to copolymerize with ethylene is not specifically defined. Relative to all the monomer units in the copolymer (B-1) of ethylene and an α-olefin having from 3 to 20 carbon atoms, the content of the α-olefin to copolymerize with ethylene is generally 2 % by mole or more, but preferably 40 % by mole or less, more preferably from 3 to 30 % by mole, even more preferably from 5 to 25 % by mole. Falling within the range, the copolymerization component can reduce the crystallinity and the transparency of the copolymer can be thereby increased; and another advantage is that the raw material pellets hardly undergo failures such as blocking, etc. The type and the content of the monomer to copolymerize with ethylene may be determined through qualitative and quantitative analysis according to a known method, for example, using a nuclear magnetic resonance (NMR) apparatus or any other analyzer.

The copolymer (B-1) of ethylene and an α-olefin having from 3 to 20 carbon atoms may contain any monomer unit based on other monomers than α-olefins. The additional monomer includes, for example, cyclic olefins, vinyl-aromatic compounds (styrene, etc.), polyene compounds, etc. The content of the additional monomer unit is preferably 20 % by mole or less based on 100 % by mole of all the monomer units in the copolymer (B-1) of ethylene and an α-olefin having from 3 to 20 carbon atoms, more preferably 15 % by mole or less.

The three-dimensional configuration, the branching, the branching degree distribution, the molecular weight distribution, and the copolymerization type (random, block, etc.) of the copolymer (B-1) of ethylene and an α-olefin having from 3 to 20 carbon atoms are not specifically defined. For example, a copolymer having long-chain branches could generally have good mechanical properties and have advantages in that its melt tension in molding into sheets is high and the calendering moldability thereof is good.

The melt flow rate (MFR) of the copolymer (B-1) of ethylene and an α-olefin having from 3 to 20 carbon atoms for use in the present invention is not specifically defined, but generally from 0.5 to 100 g/10 min or so as MFR thereof (JIS K7210, temperature: 190°C, load: 21.18 N), preferably from 1 to 50 g/10 min, more preferably from 2 to 50 g/10 min, even more preferably from 3 to 30 g/10 min.

The MFR may herein be selected in consideration of the moldability and the workability in molding into sheets, the adhesiveness and the spreadability in sealing solar cell elements (cells), etc. For example, when sheets are produced through calender-molding, the MFR is preferably a relatively low value, concretely from 0.5 to 5 g/10 min or so in view of the handleability in peeling the sheet from molding rolls; but when sheets are produced through extrusion molding using a T-die, the MFR is preferably from 1 to 50 g/10 min, more preferably from 2 to 50 g/10 min, even more preferably from 3 to 30 g/10 min from the viewpoint of reducing the extrusion load and increasing the extrusion output. Further, from the viewpoint of the adhesiveness and the spreadability in sealing solar cell elements (cells), the MFR is preferably from 2 to 50 g/10 min, more preferably from 3 to 30 g/10 min.

The production method for the copolymer (B-1) of ethylene and an α-olefin having from 3 to 20 carbon atoms for use in the present invention is not specifically defined, for which is employable any known polymerization method using a known olefin polymerization catalyst. For example, there are mentioned a slurry polymerization method, a solution polymerization method, a vapor-phase polymerization method or the like using a multi-site catalyst such as typically a Ziegler-Natta catalyst, or a single-site catalyst such as typically a metallocene catalyst or a post-metallocene catalyst, and a bulk polymerization method using a radical initiator, etc. In the present invention, from the viewpoint of attaining easy granulation (pelletization) after polymerization and also from the viewpoint of preventing the raw material pellets from blocking together, preferred is a polymerization method using a single-site catalyst, in which a raw material can be polymerized to give a polymer having low content of low-molecular-weight components and having a narrow molecular weight distribution.

The heat of crystal fusion of the copolymer (B-1) of ethylene and an α-olefin having from 3 to 20 carbon atoms for use in the present invention, as measured at a heating rate of 10°C/min in differential scanning calorimetry, is preferably from 0 to 70 J/g. Falling within the range, the copolymer is preferred because the softness and the transparency (total light transmission) of the encapsulant to be obtained are then secured. Taking the matter into consideration that the raw material pellets would not readily block together in a high temperature condition in summer or the like, the heat of crystal fusion is preferably from 5 to 70 J/g, more preferably from 10 to 65 J/g. Reference values of the heat of crystal fusion are about from 170 to 220 J/g for an ordinary high-density polyethylene (HDPE), and about from 100 to 160 J/g for a low-density polyethylene resin (LDPE) or a linear low-density polyethylene (LLDPE).

The heat of crystal fusion may be measured at a heating rate of 10°C/min, using a differential scanning calorimeter and according to JIS K7122.

Specific examples of the copolymer (B-1) of ethylene and an α-olefin having from 3 to 20 carbon atoms for use in the present invention include Dow Chemical's trade names "ENGAGE", "AFFINITY" and "INFUSE", Exxon Mobile's trade name "EXACT", Mitsui Chemical' s trade names "TAFMER H", "TAFMER A" and TAFMER P", LG Chemical's trade name "LUCENE", Japan Polyethylene's trade name "KARNEL", etc.

### (B-2)

(B-2) is a copolymer of propylene and any other monomer copolymerizable with propylene, or a homopolymer of propylene. The copolymer is not specifically defined in point of the copolymerization type (random, block, etc.), the branching, the branching degree distribution and the three-dimensional configuration thereof, and may include any polymer of isotactic, atactic or syndiotactic ones or mixtures thereof.

Examples of the other monomer copolymerizable with propylene include ethylene; α-olefins having from 4 to 12 carbon atoms such as 1-butene, 1-hexene, 4-methyl-pentene-1, 1-octene, etc.; dienes such as divinylbenzene, 1,4-cyclohexadiene, dicyclopentadiene, cyclooctadiene, ethylidenenorbornene, etc.

In the present invention, from the viewpoint of the industrial availability and various characteristics thereof and also from the economic efficiency thereof, ethylene and 1-butene are preferably used as the α-olefin to copolymerize with propylene. Further from the viewpoint of the transparency and the softness thereof, a propylene-α-olefin random copolymer is preferred for use herein. The monomers to copolymerize with propylene may be used alone or in combination of two or more thereof.

The content of the other monomer copolymerizable with propylene is not specifically defined. Relative to all the monomer units in the copolymer (B-2), the content of the other monomer copolymerizable with propylene is generally 2 % by mole or more but preferably 40 % by mole or less, more preferably from 3 to 30 % by mole, even more preferably from 5 to 25 % by mole. Falling within the range, the copolymerization component can reduce the crystallinity and the transparency of the copolymer can be thereby increased; and another advantage is that the raw material pellets hardly undergo failures such as blocking, etc. The type and the content of the other monomer copolymerizable with propylene may be determined through qualitative and quantitative analysis according to a known method, for example, using a nuclear magnetic resonance (NMR) apparatus or any other analyzer.

The melt flow rate (MFR) of (B-2) for use in the present invention is not specifically defined, but generally from 0.5 to 100 g/10 min or so as MFR thereof (JIS K7210, temperature: 230°C, load: 21.18 N), preferably from 2 to 50 g/10 min, more preferably from 3 to 30 g/10 min.

The MFR may herein be selected in consideration of the moldability and the workability in molding into sheets, the adhesiveness and the spreadability in sealing solar cell elements (cells), etc. For example, when sheets are produced through calender-molding, the MFR is preferably a relatively low value, concretely from 0.5 to 5 g/10 min or so in view of the handleability in peeling the sheet from molding rolls; but when sheets are produced through extrusion molding using a T-die, the MFR is preferably from 2 to 50 g/10 min, more preferably from 3 to 30 g/10 min from the viewpoint of reducing the extrusion load and increasing the extrusion output. Further, from the viewpoint of the adhesiveness and the spreadability in sealing solar cell elements (cells), the MFR is preferably from 2 to 50 g/10 min, more preferably from 3 to 30 g/10 min.

The production method for (B-2) a copolymer of propylene and any other monomer copolymerizable with propylene or a homopolymer of propylene for use in the present invention is not specifically defined, for which is employable any known polymerization method using a known olefin polymerization catalyst. For example, there are mentioned a slurry polymerization method, a solution polymerization method, a vapor-phase polymerization method or the like using a multi-site catalyst such as typically a Ziegler-Natta catalyst, or a single-site catalyst such as typically a metallocene catalyst or a post-metallocene catalyst, and a bulk polymerization method using a radical initiator, etc. In the present invention, from the viewpoint of attaining easy granulation (pelletization) after polymerization and also from the viewpoint of preventing the raw material pellets from blocking together, preferred is a polymerization method using a single-site catalyst, in which a raw material can be polymerized to give a polymer having a low content of low-molecular-weight components and having a narrow molecular weight distribution.

Specific examples of (B-2) for use in the present invention include a propylene-butene random copolymer, a propylene-ethylene random copolymer and a propylene-ethylene-butene-1 copolymer, etc.; and concrete commercial products thereof include Mitsui Chemical's trade names "TAFMER XM" and "NOTIO", Sumitomo Chemical's trade name "TAFFCELLEN", Prime Polymer's trade name "PRIME TPO", Dow Chemical's trade name "VERSIFY", Exxon Mobile's trade name "VISTAMAXX", etc.

### (B-3)

(B-3) is a metal salt of a copolymer of an α-olefin such as ethylene, propylene or the like and an aliphatic unsaturated carboxylic acid (in which the metal is preferably Zn, Na, K, Li, Mg or the like).

Concrete commercial products of the metal salt include Mitsui Chemical's trade name "HIMILAN", Dow Chemical's trade name "AMPLIFY IO", etc.

### (B-4)

(B-4) is an ethylene-based copolymer of ethylene and at least one monomer selected from a vinyl acetate, an aliphatic unsaturated carboxylic acid and an alkyl ester of an aliphatic unsaturated monocarboxylic acid.

Concretely, there are mentioned ethylene-acrylic acid copolymers, ethylene-methacrylic acid copolymers, ethylene acrylate copolymers, ethylene methacrylate copolymers, etc. As the ester component here, there are mentioned esters with an alkyl having from 1 to 8 carbon atoms, such as methyl, ethyl, propyl, butyl and the like. In the present invention, the copolymer is not limited to the above-mentioned binary copolymer, but may include ternary or more polynary copolymers with any additional third component added thereto (for example, ternary or more copolymers of ethylene and any others suitably selected from aliphatic unsaturated carboxylic acids and aliphatic unsaturated carboxylates). The content of the comonomer to copolymerize with ethylene is generally from 5 to 35% by mass relative to all the monomer units in the copolymer.

When the encapsulant (B) comprising a resin composition containing, as a main ingredient thereof, an olefin-based polymer of (B-1) to (B-4) described above is used as the encapsulant (B) on the back sheet side, the melt flow rate (MFR) of the encapsulant (B) is not specifically defined as long as it satisfies the projection index described later, but it is preferred that the encapsulant (B) on the back sheet side satisfies the following Requirement (P) in order to improve the appearance to which the present invention is directed.

Requirement (P): a resin composition to constitute the encapsulant (B) contains an olefin-based polymer (X) having an MFR (JIS K7210, temperature: 190°C, load: 21.18 N) of less than 5 g/10 min and an olefin-based polymer (Y) having an MFR (JIS K7210, temperature: 190°C, load: 21.18 N) of 5 g/10 min or more.

The appearance to which the present invention is directed can be further improved by adjusting the MFR of the resin to constitute the encapsulant (B) used on the back sheet side. Concretely, when the resin composition to constitute the encapsulant (B) on the back sheet side contains an olefin-based polymer (X) having an MFR (JIS K7210, temperature: 190°C, load: 21.18 N) of less than 5 g/10 min, the elastic modulus in the lamination temperature range is increased, resulting in the reduction of the projection index and suppression of the projection appearance, which is preferable. In addition, when the olefin-based polymer (Y) having an MFR (JIS K7210, temperature: 190°C, load: 21.18 N) of 5 g/10 min or more is contained, the flowability in the lamination temperature range is enhanced, leading to a good spreadability into steps or gaps between solar cell elements (cells) or wirings, and as a result, the flatness of the back sheet surface is preferably enhanced. Too small MFR may lead to reduction of the flowability in the lamination temperature range and deterioration of the spreadability into steps between the solar cell elements (cells) or wirings. Too large MFR may lead to too large flowability in the lamination temperature range, thereby causing problems such as flowing out of the encapsulation material from the end surface of the solar cell module. From the above viewpoints, it is preferred in the present invention that the MFR (JIS K7210, temperature: 190°C, load: 21.18 N) of the olefin-based polymer (X) contained in the resin composition to constitute the encapsulant (B) on the back sheet side is 0.5 g/10 min or more and less than 5 g/10 min, and the MFR (JIS K7210, temperature: 190°C, load: 21.18 N) of the olefin-based polymer (Y) contained in the resin composition to constitute the encapsulant (B) on the back sheet side is 5 g/10 min or more and 100 g/10 min or less. More preferably, the MFR of the olefin-based polymer (X) is 0. 8 g/10 min or more and less than 4 g/10 min, the MFR of the olefin-based polymer (Y) is 5 g/10 min or more and 50 g/10 min or less. Still more preferably, the MFR of the olefin-based polymer (X) is 1 g/10 min or more and less than 3 g/10 min, and the MFR of the olefin-based polymer (Y) is 5 g/10 min or more and 30 g/10 min or less.

In the present invention, the types of the olefin-based polymer (X) and the olefin-based polymer (Y) contained in the resin composition to constitute the encapsulant (B) used on the back sheet side are not specifically defined, and one type each or two or more types each may be used.

The mixing ratio by mass of the olefin-based polymer (X) and the olefin-based polymer (Y) contained in the resin composition to constitute the encapsulant (B) used on the back sheet side is preferably (95 to 55) / (5 to 45). When the mixing ratio by mass falls within this range, the projection appearance and the flatness of the solar cell module obtained after lamination can be preferably achieved in a well-balanced manner. From the above viewpoint, the mixing ratio by mass of the olefin-based polymer (X) and the olefin-based polymer (Y) is preferably (90 to 60)/(10 to 40), and more preferably (85 to 65) / (15 to 35).

The resin composition to constitute the encapsulant (B) used on the back sheet side may contain other resins described later, but the total of the olefin-based polymer (X) and the olefin-based polymer (Y) preferably accounts for 50% by mass or more of the resin composition, more preferably 70% by mass or more, and still more preferably 90% by mass or more. The upper limit is not specifically defined, but preferably it is 100% by mass or less.

When contained in the resin composition to constitute the encapsulant having a laminate configuration described later, the olefin-based polymer (X) and the olefin-based polymer (Y) do not need to be contained in the same layer as long as the mixing ratio by mass falls within in the above range, but both the polymers are preferably contained in the same layer. More preferably, both the polymers are contained in the resin composition to constitute each layer of the encapsulant having a laminate configuration.

In the present invention, encapsulants other than one on the back sheet side may or may not satisfy the Requirement (P) described above, and the melt flow rate (MFR) thereof are not specifically defined. The encapsulants other than one used on the back sheet side in this context is an encapsulant to be used on the front sheet side or in a cushion layer. In general, an encapsulant having an MFR (JIS K7210, temperature: 190°C, load: 21.18 N) of about from 0.5 to 100 g/10 min, preferably from 2 to 50 g/10 min, and more preferably from 3 to 30 g/10 min is used.

The MFR may be selected in consideration of the moldability and the workability in molding into sheets, the adhesiveness and the spreadability in sealing solar cell elements (cells), etc. For example, when sheets are produced through calender-molding, the MFR is preferably a relatively low value, concretely from 0.5 to 5 g/10 min or so in view of the handleability in peeling the sheet from molding rolls; but when sheets are produced through extrusion molding using a T-die, the MFR is preferably from 2 to 50 g/10 min, more preferably from 3 to 30 g/10 min from the viewpoint of reducing the extrusion load and increasing the extrusion output. Furthermore, from the viewpoint of the adhesiveness and the spreadability in sealing solar cell elements (cells), the MFR is preferably from 2 to 50 g/10 min, more preferably from 3 to 30 g/10 min.

The encapsulant (B) for use in the present invention has a single-layer or laminate configuration, but preferably has a laminate configuration for attaining the characteristics necessary for encapsulant in a well-balanced manner. Here the characteristics that are generally required for encapsulant are softness and impact resistance for protecting solar cell elements, heat resistance for protecting solar cell modules in heat generation, transparency (total light transmission, etc.) for efficient arrival of sunlight to solar cell elements, adhesiveness to various adherends (glass, back sheet, etc.), as well as durability, dimensional stability, flame retardance, water vapor barrier property, economic efficiency, etc. Above all, softness, balance of heat resistance and transparency, and economic efficiency are considered to be specifically important.

### (Crystal Melting Peak Temperature of Olefin-Based Polymer)

Emphasizing the softness of the encapsulant, it is desirable that the crystal melting peak temperature (Tm) of the main ingredient, olefin-based polymer is lower than 100°C, however in the present invention, a polymer not expressing a crystal melting peak temperature, that is an amorphous polymer is also employable (hereinafter including an amorphous polymer, the polymer of the type is referred to as an olefin-based polymer having a crystal melting peak temperature of lower than 100°C). In consideration of the trouble of blocking of raw material pellets, it is desirable that the crystal melting peak temperature is from 30 to 95°C, more desirably from 45 to 80°C, even more desirably from 60 to 80°C.

Emphasizing the heat resistance of the encapsulant, it is desirable that the olefin-based polymer having a crystal melting peak temperature (Tm) of lower than 100°C is mixed with an olefin-based polymer having a crystal melting peak temperature (Tm) of 100°C or higher for use herein. The upper limit of the crystal melting peak temperature (Tm) of the additional olefin-based polymer to be mixed here is not specifically defined; however, in consideration of the risk of thermal degradation of solar cell elements (cells) or the preset lamination temperature in production of solar cell modules, the upper limit is 150°C or so. In the present invention, the upper limit of the crystal melting peak temperature (Tm) of the additional olefin-based polymer to be mixed is preferably 130°C or lower, more preferably 125°C or lower because the preset lamination temperature in the process of producing solar cell modules can then be lowered and therefore the solar cell elements (cells) to be used therein hardly undergo thermal degradation.

Some reference data of the crystal melting peak temperature are shown here. Ordinary high-density polyethylene resin (HDPE) has from 130 to 145°C or so; low-density polyethylene resin (LDPE) and linear low-density polyethylene (LLDPE) have from 100 to 125°C or so; ordinary homopolypropylene resin has 165°C or so; ordinary propylene-ethylene random copolymer has from 130 to 150°C or so. The crystal melting peak temperature can be measured at a heating rate of 10°C/min, using a differential scanning calorimeter and according to JIS K7121.

Preferably, the encapsulant (B) for use in the present invention comprises a resin composition that contains an olefin-based polymer having a crystal melting peak temperature of lower than 100°C and an olefin-based polymer having a crystal melting peak temperature of 100°C or higher, as described above. When an encapsulant satisfying the Requirement (P) is used as the encapsulant on the back sheet side, it is preferred that the encapsulant satisfies the Requirement (P) and in addition, contains an olef in-based polymer having a crystal melting peak temperature of lower than 100°C and an olefin-based polymer having a crystal melting peak temperature of 100°C or higher.

The contents of the two olefin-based polymers in the resin composition are herein not specifically defined; however, in consideration of the softness, the heat resistance, the transparency of the encapsulant to be obtained, etc., the blend (content) ratio by mass of the two olefin-based polymers (olefin-based polymer having a crystal melting peak temperature of lower than 100°C/olefin-based polymer having a crystal melting peak temperature of 100°C or higher) is preferably (99 to 50)/(1 to 50), more preferably (98 to 60) / (2 to 40), even more preferably (97 to 70) / (3 to 30), still more preferably (97 to 80)/(3 to 20), even still more preferably (97 to 90) / (3 to 10), in which the total of the two olefin-based polymers is 100 parts by mass. The blend (content) ratio by mass falling within the above range is preferred because it facilitates the provision of encapsulants excellent in balance of softness, heat resistance, transparency, etc.

The olefin-based polymer having a crystal melting peak temperature of 100°C or higher that may be mixed in the encapsulant (B) for use in the present invention may be suitably selected in consideration of the desired characteristics thereof, and in the present invention, most suitably used is an ethylene-α-olefin block copolymer since it is excellent in balance of heat resistance, softness, low-temperature characteristics, etc.

<Ethylene-α-Olefin Block Copolymer>

The block structure of the ethylene-α-olefin block copolymer is not specifically defined but is preferably a multi-block structure comprising two or more segments or blocks differing from each other in point of the comonomer content, the crystallinity, the density, the crystal melting peak temperature (Tm) or the glass transition temperature (Tg) thereof, from the viewpoint of attaining well-balanced softness, heat resistance, transparency and others. Concretely, there are mentioned a completely symmetric block structure, an asymmetric block structure, a tapered block structure (in which the proportion of the block structures gradually increases in the main chain), etc. Regarding the configuration of the copolymer having the multi-block structure and the production method for the copolymer, those disclosed in detail in WO2005/090425, WO2005/090426, WO2005/090427 and others may be hereby incorporated by reference.

The ethylene-α-olefin block copolymer having a multi-block structure is described in detail hereinunder.

The ethylene-α-olefin block copolymer having a multi-block structure is favorably used in the present invention, and preferred is an ethylene-octene multi-block copolymer in which 1-octene is the comonomer as α-olefin. The block copolymer is preferably a multi-block copolymer that comprises two or more, nearly amorphous soft segments in which the proportion of the copolymerized octene component is large (about 15 to 20 % by mole) relative to ethylene, and two or more, high-crystalline hard segments in which the proportion of the copolymerized octene component is small (less than about 2 % by mole) relative to ethylene and which have a crystal melting peak temperature of from 110 to 145°C. By controlling the chain length and the proportion of these soft segments and hard segments therein, the block copolymer can be made to satisfy both softness and heat resistance.

Specific examples of the multi-block structure-having copolymer include Dow Chemical's trade name "INFUSE".

For the surface of the encapsulant (B) for use in the present invention, handleability and air bleedability as well as adhesiveness to various adherends (glass, back sheet, etc.) are required as important functions. Therefore, as the encapsulant (B) in the present invention, preferably used is a resin composition which a silane coupling agent mentioned below is added to or a silane-modified ethylene-based resin mentioned below is mixed in.

### (Silane-Modified Ethylene-based Resin)

The silane-modified ethylene-based resin is now described.

The silane-modified ethylene-based resin for use in the present invention is generally obtained by melting and mixing a polyethylene-based resin, a vinylsilane compound and a radical generator at a high temperature (160°C to 220°C or so) to thereby graft-polymerize them.

### <Polyethylene-based Resin>

The polyethylene-based resin is not specifically defined. Concretely, there are mentioned low-density polyethylene, middle-density polyethylene, high-density polyethylene, ultra-low-density polyethylene, and linear low-density polyethylene. These may be used alone or in combination of two or more thereof. Especially preferably used is polyethylene mentioned as (B-1) hereinabove.

In the present invention, preferably used is a polyethylene-based resin having a low density since such a resin has excellent transparency and flexibility. Concretely, preferred is a polyethylene-based resin having a density of from 0. 850 to 0. 920 g/cm³, and especially preferred is a linear low-density polyethylene having a density of from 0.860 to 0.880 g/cm³. A polyethylene-based resin having a low density and a polyethylene-based resin having a high density can be combined for use herein. Combined use of the resins is preferred because it achieves relatively easy control of the balance of transparency, flexibility and heat resistance.

### <Vinylsilane Compound>

The vinylsilane compound may be, but not specifically defined to, any one capable of graft-copolymerizing with the above-mentioned polyethylene-based resin. For example, there are mentioned vinyltrimethoxysilane, vinyltriethoxysilane, vinyltripropoxysilane, vinyltriisopropoxysilane, vinyltributoxysilane, vinyltripentyloxysilane, vinyltriphenoxysilane, vinyltribenzyloxysilane, vinyltrimethylenedioxysilane, vinyltriethylenedioxysilane, vinylpropionyloxysilane, vinyltriacetoxysilane, and vinyltricarboxysilane. These vinylsilane compounds may be used alone or in combination of two or more thereof. In the present invention, preferred is use of vinyltrimethoxysilane from the viewpoint of the reactivity, the adhesiveness and the color of the composition.

The amount of the vinylsilane compound to be added is not specifically defined, but generally from 0.01 to 10.0 parts by mass or so relative to 100 parts by mass of the polyethylene-based resin to be used, more preferably from 0.3 to 8.0 parts by mass, even more preferably from 1.0 to 5.0 parts by mass.

### <Radical Generator>

The radical generator includes, but not specifically defined to, organic peroxides, for example, hydroperoxides such as diisopropylbenzene hydroperoxide, 2,5-dimethyl-2,5-di(hydroperoxy)hexane, etc.; dialkyl peroxides such as di-t-butyl peroxide, t-butylcumyl peroxide, dicumyl peroxide, 2,5-dimethyl-2,5-di(t-butylperoxy)hexane, 2,5-dimethyl-2,5-di(t-peroxy)hexyne-3, etc.; diacyl peroxides such as bis-3,5,5-trimethylhexanoyl peroxide, octanoyl peroxide, benzoyl peroxide, o-methylbenzoyl peroxide, 2,4-dichlorobenzoyl peroxide, etc.; peroxyesters such as t-butylperoxy acetate, t-butylperoxy-2-ethyl hexanoate, t-butylperoxy pivalate, t-butylperoxy octoate, t-butylperoxyisopropyl carbonate, t-butylperoxy benzoate, di-t-butylperoxy phthalate, 2,5-dimethyl-2,5-di(benzoylperoxy)hexane, 2,5-dimethyl-2,5-di(benzoylperoxy)hexyne-3, etc.; ketone peroxides such as methyl ethyl ketone peroxide, cyclohexanone peroxide, etc.; azo compounds such as azobisisobutyronitrile, azobis(2,4-dimethylvaleronitrile), etc. These radical initiators may be used alone or in combination of two or more thereof.

The amount of the radical generator to be added is not specifically defined, but generally from 0.01 to 5.0 parts by mass or so relative to 100 parts by mass of the polyethylene-based resin to be used, more preferably from 0. 02 to 1.0 part by mass, even more preferably from 0.03 to 0.5 parts by mass. The amount of the remaining radical generator is preferably 0.001% by mass or less in the resin composition to constitute the encapsulant (B) for use in the present invention. Furthermore, the gel fraction in the encapsulant (B) for use in the present invention is preferably at most 30%, more preferably at most 10%, even more preferably at most 5%, still more preferably 0%.

Preferably, the silane-modified ethylene-based resin and the resin composition for use in the present invention do not substantially contain a silanol condensation catalyst which promotes condensation between silanols. Specific examples of the silanol condensation catalyst include, for example, dibutyltin diacetate, dibutyltin dilaurate, dibutyltin dioctate, dioctyltin dilaurate, etc.

"Substantially not containing" as referred to herein means that the content is 0.05 parts by mass or less relative to 100 parts by mass of the resin composition, preferably 0.03 parts by mass or less, and especially preferably 0.00 part by mass.

The reason why it is desirable that the resin does not substantially contain a silanol condensation catalyst is that, in the present invention, it is intended that the silanol crosslinking reaction is not positively promoted but the adhesiveness is expressed by the interaction such as the hydrogen bond or the covalent bond between the polar group such as the silanol group grafted on the polyethylene-based resin to be used and the adherend (glass, various plastic sheets (preferably those surface-treated through corona treatment or the like in any desired manner and having a wettability index of 50 mN/m or higher), metals, etc.).

The silane-modified ethylene-based resin for use in the present invention is generally obtained by melting and mixing a polyethylene-based resin, a vinylsilane compound and a radical generator at a high temperature (160°C to 220°C or so) to thereby graft-polymerize them, as described hereinabove. Accordingly, the preferred ranges of the density and MFR of the silane-modified ethylene-based resin used in the present invention are the same as the preferred ranges of the density and MFR of the polyethylene-based resin described above, respectively.

Specific examples of the silane-modified ethylene-based resin for use in the present invention include Mitsubishi Chemical's trade name "LINKLON".

### <Additives>

If desired, various types of additives may be added to the resin composition to constitute the encapsulant (B) for use in the present invention. The additives include, for example, a silane coupling agent, an antioxidant, a UV absorbent, a weather-resistant stabilizer, a light diffusing agent, a heat releasing agent, a nucleating agent, a pigment (e.g., titanium oxide, carbon black, etc.), a flame retardant, a discoloration inhibitor, etc. In the present invention, it is desirable that the encapsulant (B) contains at least one additive selected from a silane coupling agent, an antioxidant, a UV absorbent and a weather-resistant stabilizer, for the reason mentioned below or the like. In the present invention, it is unnecessary to add a crosslinking agent and a crosslinking promoter to the resin composition to constitute the encapsulant, however, the invention does not exclude the addition, and, for example, in case where high-level heat resistance is desired for the encapsulant, a crosslinking agent and/or a crosslinking promoter may be added to the composition. Preferably, in the present invention, the encapsulant (B) to be used is an encapsulant that is not substantially crosslinked. The phrase "not substantially crosslinked" herein means that the xylene soluble content in the composition, as measured according to ASTM 2765-95, is at least 70%, preferably 85% or more, more preferably 95% or more.

### <Silane Coupling Agent>

The silane coupling agent is effective for enhancing the adhesiveness of the encapsulant to a protective material (front sheet, back sheet and others made of glass or resin, etc.) and to solar cell elements and others; and as its examples, there are mentioned compounds having an unsaturated group such as a vinyl group, an acryloxy group or a methacryloxy group, as well as an amino group, an epoxy group or the like, and additionally having a hydrolysable group such as an alkoxy group. Concrete examples of the silane coupling agent include N-(β-aminoethyl)-γ-aminopropyltrimethoxysilane, N-(β-aminoethyl)-γ-aminopropylmethyldimethoxysilane, γ-aminopropyltriethoxysilane, γ-glycidoxypropyltrimethoxysilane, γ-methacryloxypropyltrimethoxysilane, etc. These silane coupling agents may be used alone or in combination of two or more thereof.

In the present invention, preferred is use of γ-glycidoxypropyltrimethoxysilane and γ-methacryloxypropyltrimethoxysilane because these compounds secure good adhesiveness and cause little discoloration such as yellowing.

The amount of the silane coupling agent to be added is generally from 0.1 to 5 parts by mass or so relative to 100 parts by mass of the resin composition to constitute the encapsulant (B), preferably from 0.2 to 3 parts by mass. Like the silane coupling agent, any other coupling agent such as an organic titanate compound or the like may also be used effectively here.

### <Antioxidant>

Various commercial products are usable here as the antioxidant. There are mentioned various types of antioxidants such as monophenol-type, bisphenol-type, polymeric phenol-type, sulfur-containing, and phosphite-type antioxidants, etc. The monophenol-type antioxidants include, for example, 2,6-di-tert-butyl-p-cresol, butylated hydroxyanisole, 2,6-di-tert-butyl-4-ethylphenol, etc. The bisphenol-type antioxidants include 2,2'-methylene-bis-(4-methyl-6-tert-butylphenol), 2,2'-methylene-bis-(4-ethyl-6-tert-butylphenol), 4,4'-thiobis-(3-methyl-6-tert-butylphenol), 4,4'-butylidene-bis-(3-methyl-6-tert-butylphenol), 3,9-bis[{1,1-dimethyl-2-{β-(3-tert-butyl-4-hydroxy-5-methy lphenyl)propionyloxy}ethyl}2,4,9,10-tetraoxaspiro]5,5-unde cane, etc.

The polymeric phenol-type antioxidants include 1,1,3-tris-(2-methyl-4-hydroxy-5-tert-butylphenyl)butane, 1,3,5-trimethyl-2,4,6-tris(3,5-di-tert-butyl-4-hydroxybenz yl)benzene, tetrakis-{methylene-3-(3',5'-di-tert-butyl-4'-hydroxypheny l)propionate}methane, bis{(3,3'-bis-4'-hydroxy-3'-tert-butylphenyl)butyric acid} glucose ester, 1,3,5-tris(3',5'-di-tert-butyl-4'-hydroxybenzyl)-s-triazin ee-2,4,6-(1H,3H,5H)trione, tocopherol(vitamin E), etc.

The sulfur-containing antioxidants include dilauryl thiodipropionate, dimyristyl thiodipropionate, distearyl thiopropionate, etc.

The phosphite-type antioxidants include triphenyl phosphite, diphenylisodecyl phosphite, phenyldiisodecyl phosphite, 4,4'-butylidene-bis(3-methyl-6-tert-butylphenyl-di-tridecy 1) phosphite, cyclic neopentanetetrayl bis(octadecyl phosphite), tris(mono and/or di)phenyl phosphite, diisodecyl pentaerythritol diphosphite, 9,10-dihydro-9-oxa-10-phosphaphenanthrene-10-oxide, 10-(3,5-di-tert-butyl-4-hydroxybenzyl)-9,10-dihydro-9-oxa-10-phosphaphenanthrene-10-oxide, 10-decyloxy-9,10-dihydro-9-oxa-10-phosphaphenanthrene, cyclic neopentanetetrayl bis(2,4-di-tert-butylphenyl) phosphite, cyclic neopentanetetrayl bis(2,6-di-tert-methylphenyl) phosphite, 2,2-methylenebis(4,6-tert-butylphenyl)octyl phosphite, etc.

The above antioxidants may be used alone or in combinatioan of two or more thereof.

In the present invention, preferably used are phenol-type antioxidants such as monophenol-type, bisphenol-type and polymeric phenol-type ones, as well as phosphite-type antioxidants from the viewpoint of the effect, the thermal stability and the economic efficiency thereof, and more preferably the two different types of those antioxidants are combined for use herein. The amount of the antioxidant to be added is generally from 0.1 to 1 part by mass or so relative to 100 parts by mass of the resin composition to constitute the encapsulant (B), preferably from 0.2 to 0.5 parts by mass.

### <UV Absorbent>

Various commercial products are usable here as the UV absorbent, including various types of benzophenone-type, benzotriazole-type, triazine-type or salicylate-type UV absorbents and others. The benzophenone-type UV absorbents include, for example, 2-hydroxy-4-methoxybenzophenone, 2-hydroxy-4-methoxy-2'-carboxybenzophenone, 2-hydroxy-4-octoxybenzophenone, 2-hydroxy-4-n-dodecyloxybenzophenone, 2-hydroxy-4-n-octadecyloxybenzophenone, 2-hydroxy-4-benzyloxybenzophenone, 2-hydroxy-4-methoxy-5-sulfobenzophenone, 2-hydroxy-5-chlorobenzophenone, 2,4-dihydroxybenzophenone, 2,2'-dihydroxy-4-methoxybenzophenone, 2,2'-dihydroxy-4,4'-dimethoxybenzophenone, 2,2',4,4'-tetrahydroxybenzophenone, etc.

The benzotriazole-type UV absorbents include hydroxyphenyl-substituted benzotriazole compounds, for example, 2-(2-hydroxy-5-methylphenyl)benzotriazole, 2-(2-hydroxy-5-t-butylphenyl)benzotriazole, 2-(2-hydroxy-3,5-dimethylphenyl)benzotriazole, 2-(2-methyl-4-hydroxyphenyl)benzotriazole, 2-(2-hydroxy-3-methyl-5-t-butylphenyl)benzotriazole, 2-(2-hydroxy-3,5-di-t-amylphenyl)benzotriazole, 2-(2-hydroxy-3,5-di-t-butylphenyl)benzotriazole, etc. The triazine-type UV absorbents include 2-[4,6-bis(2,4-dimethylphenyl)-1,3,5-triazin-2-yl]-5-(octy loxy)phenol, 2-(4,6-diphenyl-1,3,5-triazin-2-yl)-5-(hexyloxy)phenol, etc. The salicylate-type UV absorbents include phenyl salicylate, p-octylphenyl salicylate, etc.

The amount of the UV absorbent to be added is generally from 0.01 to 2.0 parts by mass or so relative to 100 parts by mass of the resin composition to constitute the encapsulant (B), preferably from 0.05 to 0.5 parts by mass.

### <Weather-Resistant Stabilizer>

As the weather-resistant stabilizer for imparting weather resistance apart from the above-mentioned UV absorbent, preferred is use of hindered amine-type light stabilizers. The hindered amine-type light stabilizer does not absorb UV rays, different from UV absorbents, but when combined with a UV-absorbent, it exhibits a noticeable synergistic effect. Some others than hindered amine-type compounds may function as a light stabilizer, but many of such compounds are colored and are therefore unfavorable for the encapsulant (B) for use in the present invention.

The hindered amine-type light stabilizer includes dimethyl succinate/1-(2-hydroxyethyl)-4-hydroxy-2,2,6,6-tetramethyl piperidine polycondensate, poly[{6-(1,1,3,3-tetramethylbutyl)amino-1,3,5-triazine-2,4 -diyl}{(2,2,6,6-tetramethyl-4-piperidyl)imino}hexamethylen e{{2,2,6,6-tetramethyl-4-piperidyl}imino}], N,N'-bis(3-aminopropyl)ethylenediamine-2,4-bis[N-butyl-N-( 1,2,2,6,6-pentamethyl-4-piperidyl)aminol-6-chloro-1,3,5-tr iazine condensate, bis(2,2,6,6-tetramethyl-4-piperidyl) sebacate, bis(1,2,2,6,6-pentamethyl-4-piperidyl) 2-(3,5-di-tert-4-hydroxybenzyl)-2-n-butylmalonate, etc.

The amount of the hindered amine-type light stabilizer to be added is generally from 0.01 to 0.5 parts by mass or so relative to 100 parts by mass of the resin composition to constitute the encapsulant (B), preferably from 0.05 to 0.3 parts by mass.

The softness of the encapsulant (B) for use in the present invention is not specifically defined as long as it satisfies the projection index described later. The softness may be suitably controlled in consideration of the shape and the thickness of the solar cell to which it is applied and of the site where the solar cell is installed.

For example, the storage elastic modulus (E') of the encapsulant (B) is preferably from 1 to 2000 MPa, as measured through dynamic viscoelasticity measurement at an oscillation frequency of 10 Hz and at a temperature of 20°C. In consideration of the ability thereof to protect solar cell elements and of the softness thereof, the storage elastic modulus (E') of the encapsulant (B) is preferably from 1 to 100 MPa, more preferably from 5 to 50 MPa, and still more preferably from 5 to 30 MPa. When the encapsulant (B) has a laminate configuration, the storage elastic modulus (E') is the storage elastic modulus of the entire multilayer configuration of the encapsulant. In consideration of the handleability of the encapsulant that is sampled in the form of a sheet or the like, and in consideration of preventing the surfaces of the sheet-like material from blocking together and further in consideration of weight reduction of solar cell modules (thin-filmy glass (1.1 mm or so) is applicable contrary to an ordinary glass of 3 mm or so, or glassless configuration is applicable), storage elastic modulus is preferably from 100 to 800 MPa, more preferably from 200 to 600 MPa. The storage elastic modulus (E') may be measured using a viscoelasticity measuring device at an oscillation frequency of 10 Hz over a predetermined temperature range, and the value thereof at a temperature of 20°C can be read.

The heat resistance of the encapsulant (B) for use in the present invention is influenced by various properties of the olefin-based polymer to be used (crystal melting peak temperature, heat of crystal fusion, MFR, molecular weight, etc.), and can be therefore suitably controlled by suitably selecting these properties. In particular, the crystal melting peak temperature and the molecular weight of the olefin-based polymer have significant influences thereon. In general, solar cell modules are heated up to 85°C or so by the heat generated during power generation or by the radiation heat of sunlight; however, so far as the crystal melting peak temperature is 100°C or higher, the encapsulant (B) for use in the present invention can favorably secure the heat resistance thereof.

The total light transmission (JIS K7105) of the encapsulant (B) for use in the present invention may not be so important depending on the type of the solar cells to which the encapsulant is applied, for example, in case where the encapsulant is applied to amorphous thin-film silicon parts or the like or to the other parts at which the sunlight to reach the solar cell element is not so much blocked; however, in consideration of the photoelectric conversion efficiency of solar cells to which the encapsulant is applied or of the handleability of the encapsulant in laminating various parts therewith, the total light transmission of the encapsulant is preferably 85% or more, more preferably 88% or more, even more preferably 90% or more.

The softness, the heat resistance and the transparency of the encapsulant (B) for use in the present invention may be often paradoxical properties. Concretely, when the crystallinity of the resin composition to be used is too much lowered for enhancing the softness thereof, then the heat resistance thereof may lower and may be therefore insufficient. On the other hand, when the crystallinity of the resin composition to be used is too much increased for increasing the heat resistance thereof, then the transparency may lower and may be therefore insufficient. In consideration of the balance among them, when the storage elastic modulus (E') in dynamic viscoelasticity measurement at an oscillation frequency of 10 Hz and at a temperature of 20°C is referred to as the index of softness, when the crystal melting peak temperature, as measured at a heating rate of 10°C/min in differential scanning calorimetry, of the olefin-based polymer is referred to as the index of heat resistance, and when the total light transmission is referred to as the index of transparency, it is desirable that these three indices are such that the storage elastic modulus (E') is from 1 to 2000 MPa, the crystal melting peak temperature is 100°C or higher and the total light transmission is 85% or higher, for the purpose of satisfying all those softness, heat resistance and transparency; and more preferably, the storage elastic modulus (E') is from 5 to 800 MPa, the crystal melting peak temperature is from 102 to 150°C and the total light transmission is 85% or higher, even more preferably, the storage elastic modulus (E') is from 10 to 600 MPa, the crystal melting peak temperature is from 105 to 130°C and the total light transmission is 88% or higher.

Next described is a method for producing the encapsulant (B) for use in the present invention.

The form of the encapsulant is not specifically defined. The encapsulant may be liquid or may also be a sheet, but is preferably a sheet from the viewpoint of the handleability thereof.

As the film formation method for the sheet-like encapsulant, herein employable is a known method, for example, an extrusion casting method using a T-die, a calendering method, an inflation method or the like using a melt mixing apparatus equipped with a single-screw extruder, a multi-screw extruder, a Banbury mixer, a kneader or the like. Though not specifically defined, in the present invention, preferred is an extrusion casting method using a T-die from the viewpoint of the handleability and the productivity. The molding temperature in the extrusion casting method using a T-die may be suitably controlled depending on the flow characteristics, the film formability, and the like of the resin composition to be used, but may be generally from 130 to 300°C, preferably from 150 to 250°C.

A thickness of the encapsulant is not specifically defined, but generally 0.03 mm or more, preferably 0.05 mm or more, more preferably 0.1 mm or more and is generally 1 mm or less, preferably 0.7 mm or less, more preferably 0.5 mm or less.

Various additives such as a silane coupling agent, an antioxidant, a UV absorbent, a weather-resistant stabilizer and the like may be previously dry-blended with resin and then fed into a hopper; all the materials to be pelletized may be previously melt-mixed and pelletized, and then the additives may be added thereto; or a master batch in which the additives alone are previously concentrated in resin may be prepared and fed thereinto. If desired, the front surface and/or the back surface of the encapsulant that has been formed in the form of a sheet may be embossed or may be processed in any other mode to form various recesses or projections thereon (in conical, pyramid-like, hemisphere-like or any other form), for the purpose of preventing the surfaces of the sheet from blocking together in rolling up the sheet or for the purpose of enhancing the handleability and the degassing operation in the lamination process for solar cell elements. The surface of the encapsulant may be surface-treated variously through corona treatment, plasma treatment, primer treatment or the like from the viewpoint of enhancing the adhesiveness to various adherends. Here as a target for the surface treatment level, the treated surface preferably has a wettability index of 50 mN/m or more, more preferably 52 mN/m or more. The upper limit of the wettability index is generally 70 mN/m or so.

The encapsulant (B) for use in the present invention has a single-layer or laminate configuration, but preferably has a laminate configuration composed of multiple layers differing from each other in point of the constituent ingredients therein and the compositional ratio of the constituent ingredients for attaining the characteristics necessary for the encapsulant in a well-balanced manner, as described hereinabove. More preferably, the laminate configuration is formed in coextrusion through a multi-layer die of an extruder.

One example of the laminate configuration composed of multiple layers is a laminate configuration comprising at least a soft layer and a hard layer as mentioned below. For example, the following laminate configurations are preferred here.
(1) Two-type three-layer configuration; concretely, soft layer/hard layer/soft layer, hard layer/soft layer/hard layer, adhesive layer/interlayer/adhesive layer, soft layer/regenerated added layer/soft layer, etc.;
(2) Two-type two-layer configuration; concretely, soft layer/hard layer, soft layer (I)/soft layer (II), adhesive layer/soft layer, adhesive layer/hard layer, soft layer (with additive)/soft layer (without additive), soft layer (with additive A)/soft layer (with additive B) (the additive formulation differs), etc.;
(3) Three-type three-layer configuration; concretely, soft layer/adhesive layer/hard layer, soft layer (I)/interlayer/soft layer (II), adhesive layer (I)/interlayer/adhesive layer (II), etc.;
(4) Three-type five-layer configuration; concretely, soft layer/adhesive layer/hard layer/adhesive layer/soft layer, hard layer/adhesive layer/soft layer/adhesive layer/hard layer, soft layer/regenerated added layer/hard layer/regenerated added layer/soft layer, soft layer/regenerated added layer/hard layer/regenerated added layer/hard layer, etc.

In the present invention, from the viewpoint of the balance of softness, heat resistance and transparency and of the economic efficiency, preferably used is the two-type three-layer configuration (1) such as typically soft layer/hard layer/soft layer, hard layer/soft layer/hard layer, adhesive layer/interlayer/adhesive layer, soft layer/regenerated added layer/soft layer, etc. Of the two-type three-layer configuration (1), especially preferred is a configuration of soft layer/hard layer/soft layer.

The interlayer is provided from the viewpoint of increasing the thickness of the encapsulant (B) or enhancing the desired performance thereof, and is, for example, a layer formed of a resin composition comprising an olefin-based resin as the main ingredient thereof. The regenerated added layer is provided from the viewpoint of economic rationality and effective utilization of natural resources, and is, for example, a layer formed of a resin composition prepared by regenerating the trimmings in film formation or slitting of the encapsulant (B).

The adhesive layer is provided from the viewpoint of enhancing the adhesiveness between the neighboring layers or the adhesiveness to adherends, and is, for example, a layer formed of a resin composition that contains a resin modified with a polar group such as a carboxyl group, an amino group, an imide group, a hydroxyl group, an epoxy group, an oxazoline group, a thiol group, a silanol group or the like, or a tackifier resin or the like.

As the additive, there are mentioned a silane coupling agent, an antioxidant, a UV absorbent, a weather-resistant stabilizer, a light diffusing agent, a heat releasing agent, a nucleating agent, a pigment, a flame retardant, a discoloration inhibitor, a crosslinking agent, a crosslinking promoter, etc.

Here the soft layer is a layer having a storage elastic modulus (E') in dynamic viscoelastometry at an oscillation frequency of 10 Hz and at a temperature of 20°C, of preferably less than 100 MPa, more preferably from 5 to 50 MPa, and the hard layer is a layer having a storage elastic modulus (E') in dynamic viscoelastometry at an oscillation frequency of 10 Hz and at a temperature of 20°C, of preferably 100 MPa or more, more preferably from 200 to 800 MPa. The laminate configuration of the type is preferably employed because both the performance of protecting solar cell elements and the handleability (elastic modulus at room temperature, etc.) as a whole of the encapsulant are then relatively easily realized. Satisfying both rigidity and softness at room temperature would make it possible to use thin-wall glass (for example, 1.1 mm, etc.) or a glassless configuration, therefore enabling further weight reduction.

Here, the thickness of the soft layer to be kept in contact with a solar cell element is not specifically defined. In consideration of the performance to protect solar cell elements and the spreadability of resin, the thickness is preferably 0.005 mm or more, more preferably from 0.02 to 0.2 mm. In the above, the thickness of each soft layer may be the same or different. The thickness of the hard layer is not also specifically defined. From the viewpoint of the handleability of the entire encapsulant, the thickness is preferably 0.025 mm or more, more preferably from 0.05 to 0.8 mm.

Further, in the case of forming the encapsulant for use in the present invention into a sheet, any other substrate film (for example, oriented polyester film (OPET), oriented polypropylene film (OPP), or various types of weather-resistant films such as ethylene tetrafluoroethylene copolymer (ETFE), polyvinylidene fluoride (PVDF), polyvinyl fluoride (PVF) or acrylic film, etc.) may be laminated on the encapsulant according to a method of extrusion lamination, coextrusion, sandwich lamination or the like. By laminating the encapsulant (B) for use in the present invention with any other various types of substrate layers, the handleability of the resulting laminate may be enhanced, and the necessary characteristics and the economic efficiency of the laminate may be relatively readily controlled depending on the lamination ratio.

The solar cell module of the present invention is preferably a member in which the back sheet (A) and the encapsulant (B) are integrated together.

### [Back sheet-encapsulant-integrated-sheet]

The back sheet (A) and the encapsulant (B) for use in the present invention may be separated and combined with each other. Alternatively, a back sheet-encapsulant-integrated-sheet in which the back sheet and the encapsulant are integrated in advance may be suitably used. The back sheet-encapsulant-integrated-sheet in the present invention includes at least the back sheet (A) and the encapsulant (B) described above. In addition, the encapsulant

### (B) preferably satisfies the following Requirement (P)

Requirement (P) : a resin composition to constitute the encapsulant (B) contains an olefin-based polymer (X) having an MFR (JIS K7210, temperature: 190°C, load: 21.18 N) of less than 5 g/10 min and an olefin-based polymer (Y) having an MFR (JIS K7210, temperature: 190°C, load: 21.18 N) of 5 g/10 min or more.

The back sheet (A), the encapsulant (B), the olefin-based polymer (X) and the olefin-based polymer (Y) are as described above.

The use of the back sheet-encapsulant-integrated-sheet is preferable because the number of the parts can be reduced, whereby the layup step in laminating is shortened and the handleability is enhanced. In addition, the use of such a sheet is preferable also because the adhesion reliability between the back sheet layer and the encapsulant layer can be enhanced. Furthermore, since the lamination condition can be efficiently set, the time required to investigate the condition and the cost for the members can be suppressed, and as a result, significant reduction in the production cost of the solar cell module can be expected.

Next, the method of producing the back sheet-encapsulant-integrated-sheet is described. The method of producing the back sheet-encapsulant-integrated-sheet generally includes, but not specifically defined, known production methods, such as heat lamination method, dry lamination method, extrusion lamination method, calender coating method, and co-extrusion method. In the present invention, heat lamination method, dry lamination method, extrusion lamination method, and co-extrusion method are suitably used. The methods are briefly described below.

The heat lamination method is a method in which two sheets, i.e., the back sheet (A) and encapsulant (B) in the case of the present invention, are stacked, and heated and pressurized by a heat roll or the like to allow the two sheets to adhere by heat to each other.

The dry lamination method is a method in which two sheets, i.e., the back sheet (A) and encapsulant (B) in the case of the present invention, are bonded, for example, a polyurethane-based adhesive of 2-part curable type, etc., is applied on the surface to be laminated of one sheet, for example, of the back sheet (A), the solvent component is removed by hot air dry or the like, the other sheet, i.e. the encapsulant (B) is placed and pressure-bonded thereon in the tacky state before curing, the bonded sheets are, in general, wound in a roll, and stored at a normal temperature or an elevated, but relatively lower temperature to cure the adhesive with time, whereby the two sheets are bonded to each other.

The extrusion lamination method is a method in which the back sheet (A) previously made into a sheet form and the encapsulant (B) melt-extruded by a T-die or the like into a film form are pressure-bonded with a roll, and the sheets are cooled to thereby form a lamination. In this procedure, an adhesive resin or an anchor coat (one type of primer coat) may be disposed between the back sheet (A) layer and the encapsulant (B) layer.

The calender coating method is a method in which a thermoplastic resin, i.e., a resin composition to constitute the encapsulant (B) in the case of the present invention, is heated with a calendar to form a film, while placing the film on the surface to be laminated of the back sheet (A) to cover the surface, and the two sheets are pressure-bonded and cooled to thereby form a lamination. Also in this case, an anchor coat may be applied on the surface to be laminated of the back sheet (A) as desired.

The co-extrusion method is a method in which the resin composition to constitute the back sheet (A) and the resin composition to constitute encapsulant (B) are laminated using a feed block, multi-manifold die, or the like to form a film, the film is cooled by a chilled roll to pressure bond the two sheets, thereby forming a lamination. Here, an adhesive layer may be interposed between the two layers as desired.

### [Projection index (σ(A)/G'(B))]

It is important in the solar cell module of the present invention that the ratio (σ(A)/G' (B)) of the shrinkage stress (σ(A)) (Pa) of the back sheet (A) and the shear elastic modulus (G'(B)) (Pa) of the encapsulant (B) at the preset lamination temperature is 60.0 or less. Here, the shrinkage stress (σ(A)) is a measured value (Pa) for the back sheet (A) at the preset lamination temperature, the shear elastic modulus (G'(B)) is a measured value (Pa) for the encapsulant (B) at an oscillation frequency of 1Hz at a preset lamination temperature.

In the present invention, "preset lamination temperature" is a preset temperature of the laminator which is preset in stacking and laminating the back sheet (A), the encapsulant (B), cells, and an upper protective material, and "lamination temperature range" is a range of the preset lamination temperature. The preset lamination temperature is preferably 100°C or higher and 170°C or lower, more preferably 100°C or higher and 135°C or lower.

In the present invention, when the ratio (σ(A)/G'(B)) of the shrinkage stress (σ(A)) (Pa) of the back sheet (A) and the shear elastic modulus (G'(B)) (Pa) of the encapsulant (B) at the preset lamination temperature, i.e., the projection index falls within the above range, projection phenomenon of the surface of the back sheet after lamination of the solar cell module is suppressed and the appearance becomes good, and therefore this is preferable.

In the present invention, the mechanism for causing the projection phenomenon of the surface of the back sheet is presumed as follows. A typical solar cell module composed of glass/encapsulant/cells/encapsulant/back sheet is now described as an example. First, a cause of the projection phenomenon (the phenomenon of generation of the projection protrusion) on the back sheet surface may be a deformation, such as buckling or rising in a chevron form, of a wiring (lead line) between cells. This is considered to be mainly attributed to the fact that the interval between cells is reduced by the shrinkage stress due to the thermal shrinkage behavior of the back sheet occurring in the lamination temperature range (around from 100 to 170°C).

In the present invention, it was found that the ratio (σ(A)/G'(B)) of the shrinkage stress (σ(A))(Pa) of the back sheet (A) and the shear elastic modulus (G'(B)) (Pa) of the encapsulant (B) at the preset lamination temperature, i.e. the projection index has a correlation with the behavior of the reduction of interval between cells. This leads to an idea of suppressing, by controlling the elastic modulus of the encapsulant (B), the behavior of the interval between cells reduced by the shrinkage stress due to the thermal shrinkage behavior of the back sheet (A) occurring in the lamination temperature range. In more detail, the shrinkage stress due to the thermal shrinkage behavior of the back sheet (A) occurring in the lamination temperature range affects cells and wirings via the encapsulant (B) used in the present invention and generates the behavior of the reduction of interval between cells. In the present invention, it was found that the behavior can be suppressed by controlling the shear elastic modulus of the encapsulant (B) used so as to have a good balance with the shrinkage stress. That is, assuming that the shrinkage stress of the back sheet (A) is constant, the larger the shear elastic modulus of the encapsulant (B) is, the more the projection phenomenon is suppressed and the smaller the projection index is.

In the present invention, the lower limit of the projection index is generally 0 (zero). This is the case where the shrinkage stress of the back sheet (A) is 0 (zero), that is, the thermal shrinkage rate is 0 (zero). However, although the thermal shrinkage rate of the back sheet (A) can be made to 0 (zero) by methods, such as heat treatment or relaxation processing, it may not be realistic in view of the economic efficiency. From the above facts, the projection index of the present invention is preferably 0.01 or more and 60.0 or less, more preferably 0.01 or more and 40.0 or less, even more preferably 0.01 or more and 35.0 or less, still more preferably 1.0 or more and 20.0 or less.

Here, the lower the upper limit of the projection index is, the more preferred, while the lower limit is preferably 1.0 or more considering the economic efficiency and the spreadability of the encapsulant in lamination.

The method of measuring the shrinkage stress (σ(A)) (Pa) of the back sheet (A) and the shear elastic modulus (G'(B)) (Pa) of the encapsulant (B) for use in the present invention is now described.

First, the shrinkage stress (σ(A)) of the back sheet (A) is determined as follows. Three samples having a size of 70 mm in the machine direction and 10 mm in the transverse direction are cut out of the back sheet (A) to be used, both ends thereof are secured at a chuck-to-chuck distance of 50 mm, the samples are soaked in a silicone bath of the preset lamination temperature for 5 minutes, and the maximum shrinkage stresses generated in the machine direction are measured, and averaged to give the mean value (Pa) thereof.

Next, using a rheometer (Rheology's trade name "Rheometer MR-300T"), the shear elastic modulus (G' (B)) of the encapsulant (B) is determined as follows. The shear elastic modulus (G') of a sample (thickness: 0.3 mm) placed on a parallel plate of 20-mmϕ is measured under conditions of the oscillation frequency of 1 Hz, the temperature rising rate of 3°C/min and the strain of 0.5%, in a temperature range of 80°C to 200°C, and the value (Pa) at the preset lamination temperature is read.

### (Method for controlling projection index)

Next, the method for controlling the projection index is described. In order to suppress the projection phenomenon, the smaller projection index is preferred. The method for reducing the projection index mainly includes (1) a method of reducing the shrinkage stress (σ(A)) due to the thermal shrinkage behavior of the back sheet (A) at the preset lamination temperature, (2) a method of increasing the shear elastic modulus (G'(B)) of the encapsulant (B) at the preset lamination temperature and (3) a method of performing the lamination at a low temperature.

The method (1) of reducing the shrinkage stress (σ(A)) due to the thermal shrinkage behavior of the back sheet (A) at the preset lamination temperature includes, but not specifically defined to, the following methods. Exemplified are a method of subjecting the substrate to constitute the back sheet (A) or the whole back sheet (A) to a heat treatment (annealing treatment) (150 to 200°C or so) or a relaxation processing using a tenter or a roll for heat treatment to bring the thermal shrinkage behavior of the back sheet (A) close to zero, thereby reducing the shrinkage stress (σ(A)), and a method of subjecting the back sheet (A) to a heat treatment or a relaxation processing during production thereof from various substrate sheets by lamination or other processes, to bring the thermal shrinkage behavior of the back sheet (A) close to zero, thereby reducing the shrinkage stress (cr(A)), and a method of laminating a layer (for example, PE layer) having a low elastic modulus at the preset lamination temperature to suppress the elastic modulus of the back sheet (A) at the preset lamination temperature at a low value, thereby reducing the shrinkage stress (σ(A)).

In the present invention, the shrinkage stress (σ(A)) of the back sheet (A) is preferably 7 × 10⁵ Pa or less, more preferably, 6 × 10⁵ Pa or less, even more preferably 4 × 10⁵ Pa or less, and still more preferably 3 × 10⁵ Pa or less, at 130°C and 150°C. It is considered that the projection phenomenon may be more stabilized because of such a lower shrinkage stress in a wide temperature range. The lower limit of the shrinkage stress is generally 0 (zero) Pa. The thermal shrinkage rate of the back sheet (A) is 1.5% or less, more preferably 1.0% or less, even more preferably 0.8% or less, and most preferably 0.5% or less, under a condition of 150°C and 30 minutes. The lower limit of the thermal shrinkage rate is generally 0 (zero)%.

Next, the method (2) of increasing the shear elastic modulus (G' (B)) of the encapsulant (B) at the preset lamination temperature includes, but not specifically defined to, the following methods. Exemplified are a method of increasing the molecular weight of the material to constitute the encapsulant (B), a method of introducing a long, branched chain, a method of increasing the crystallizability, a method of enhancing the crystallization kinetic during cooling by adding a nucleating agent, and a method of crosslinking.

In the present invention, the method of increasing the molecular weight of the material to constitute the encapsulant (B) is suitably used, because the raw material is highly industrially available and the method is superior in terms of economic efficiency and recyclability. In the present invention, the shear elastic modulus (G'(B)) of the encapsulant (B) is preferably 1 × 10³ to 1 × 10⁵ Pa, more preferably 5 × 10³ to 5 × 10⁴ Pa, even more preferably 8 × 10³ to 3 × 10⁴ Pa, at 130°C and 150°C, and at an oscillation frequency of 1 Hz. Concretely, it is achieved by selecting the melt flow rate (MFR), and the encapsulant having an MFR (JIS K7210, temperature: 190°C, load: 21.18 N) of 0.5 to 10 g/10 min or so, more preferably 0.8 to 8 g/10 min, even more preferably 1 to 5 g/10 min may be used.

Furthermore, the projection index can be suppressed at a low value by the method (3) of performing the lamination at a low temperature. It can be achieved because, when the preset lamination temperature is low, the thermal shrinkage behavior of the back sheet (A) is suppressed and the resulting shrinkage stress (σ(A)) is small, and at the same time, the shear elastic modulus (G'(B)) of the encapsulant (B) is larger than at a higher temperature, and as a result, the projection index can be suppressed at a small value. When the preset lamination temperature is 100°C or more, the adhesion to glass or the back sheet can be preferably obtained. On the other hand, a lamination temperature of 135°C or less is preferable because the projection index can be reduced and thus the projection phenomenon can be suppressed easily. In addition, it is also effective that the lamination is performed in a time as short as possible (for example, with a vacuuming time of 5 minutes and a press retention time of 5 minutes) considering other characteristics.

Alternatively, a method of forcibly cooling the laminate after lamination, using a cooling fan, a cooling roll and a cooling belt is also effective in some cases. This is because, especially when the encapsulant (B) used is an encapsulant that does not crosslink, the encapsulant is in a state of a high temperature and a low shear elastic modulus (G'(B)) immediately after the lamination, and the method has an effect of increasing the (G'(B)) by cooling. However, this method involves problems of concern, for example, the standard specification of the lamination apparatus is not equipped with the cooling unit, or the forcibly cooling results in the strain of the glass, thereby causing a warp or the like to occur in the solar cell module.

### [Solar cell module]

Next, the solar cell module of the present invention can be produced by fixing the solar cell elements with an upper and a lower protective materials, i.e., a front sheet and the back sheet (A), using the encapsulant (B). Various types are exemplified as the solar cell module, and preferred examples thereof include a solar cell module made of an encapsulant, an upper protective material, solar cell elements, and a lower protective element. Concrete examples include the solar cell module having a configuration of upper protective material/encapsulant (encapsulant resin layer)/solar cell elements/encapsulant (encapsulant resin layer)/lower protective layer, in which the solar cell element is sandwiched between the encapsulants on both sides thereof (see Fig. 1), a solar cell module having a configuration in which an encapsulant and an upper protective material are formed on a solar cell element which is formed on the inner peripheral surface of a lower protective material, and a solar cell module having a configuration in which an encapsulant and a lower protective material are formed on a solar cell element formed on the inner peripheral surface of an upper protective material, for example, on an amorphous solar cell element formed on the fluororesin-based transparent protective material by sputtering or other methods.

Examples of the solar cell element (cell) include, but not specifically defined to, single-crystal silicon-based, polycrystal silicon-based, amorphous silicon-based, gallium-arsenic, copper-indium-selenium, cadmium-tellurium or the like III-V group or II-VI group compound semiconductor-based, dye-sensitized type, organic thin film-type or the like solar cell elements. In the present invention, preferably used are single-crystal silicon-based and polycrystal silicon-based solar cells.

Examples of the front sheet (upper protective material) include, but not specifically defined to, a single-layer or a multi-layer protective material of plate and film made of glass, acrylic resin, polycarbonate resin, polyester resin, fluororesin, etc. Especially suitably used are a glass plate in terms of the economic efficiency and physical strength, and a plate made of an acrylic resin or a polycarbonate resin having a thickness of about 5 mm is preferred in terms of the light weight and processability.

Incidentally, in the case where the encapsulant is used at two or more parts in the solar cell module of the present invention, the same encapsulant may be used for all the parts, or encapsulants having different resin compositions, different surface shapes, or different thicknesses may be used.

The solar cell module of the present invention is explained with reference to an example having a configuration of upper protective material/encapsulant (encapsulant resin layer)/solar cell elements/encapsulant (encapsulant resin layer) /lower protective layer, in which the solar cell element is sandwiched between the encapsulants on both sides thereof, as described above. As shown in Fig. 1, the solar cell module contains a transparent substrate 10, an encapsulant resin layer 12A, solar cell elements 14A and 14B, an encapsulant resin layer 12B, and a back sheet 16 laminated in order from the sunlight receiving side, and further contains a junction box 18 (a terminal box which is connected to wirings for extracting generated electrical power out of the solar cell element) bonded to the lower surface of the back sheet 16. The solar cell elements 14A and 14B are connected via a wiring 20 to electrically communicate the generated electrical current to the exterior. The wiring 20 is drawn to the exterior through a through hole (not shown) provided in the back sheet 16, and connected to the junction box 18.

To the production method for the solar cell module, applicable is any known production method, though not specifically defined, and in general, the method includes a step of stacking the upper protective material, the encapsulant resin layer, the solar cell elements, the encapsulant resin layer and the lower protective material in that order, and a step of bonding them under heat and pressure through vacuum suction, that is, a step of laminating them. To the method, also applicable are a batch-type production apparatus, a roll-to-roll type production apparatus, etc.

The solar cell module of the present invention is usable in various applications irrespective of indoor use or outdoor use, for example, for small-size solar cells such as typically those in mobile instruments, as well as large-size solar cells to be installed on roofs or rooftop decks, depending on the type of the solar cell and the module form to be applied thereto. However, the phenomenon of generation of the projection phenomenon and the problem of poor appearance to which the present invention is to solve would hardly occur in small-size modules but often occur especially in large-size modules, and therefore, the present invention is more effective in modules, for example, having a size of 90 cm × 90 cm or more, especially a size of 90 cm × 100 cm or more.

### [Examples]

The present invention is described in more detail with reference to the following Examples, however, the present invention is not limited at all by these Examples. The products described in the specification were analyzed for their data and evaluations, as mentioned below. In this analysis, the sheet running direction from extruder is referred to as a machine direction (MD), and the direction perpendicular to that direction is referred to as a transverse direction (TD).

### [Method for Measurement and Evaluation]

### (1) Crystal melting peak temperature (Tm)

Using a differential scanning calorimeter (Perkin Elmer's trade name "Pyris1 DSC") and according to JIS K7121, about 10 mg of a sample was heated from -40°C to 200°C at a heating rate of 10°C/min, kept at 200°C for 1 minutes, and then cooled down to -40°C at a cooling rate of 10°C/min, and again this was heated up to 200°C at a heating rate of 10°C/min, and on the thus-obtained thermogram, the crystal melting peak temperature (Tm) (°C) was read.

### (2) Heat of crystal fusion (ΔHm)

Using a differential scanning calorimeter (Perkin Elmer's trade name "Pyris1 DSC") and according to JIS K7122, about 10 mg of a sample was heated from -40°C to 200°C at a heating rate of 10°C/min, kept at 200°C for 1 minute, and then cooled down to -40°C at a cooling rate of 10°C/min, and again this was heated up to 200°C at a heating rate of 10°C/min, and on the thus-obtained thermogram, the heat of crystal fusion (ΔHm) (J/g) was read.

### (3) Thermal shrinkage rate

The back sheet (A) used was cut into a sample having a size of 150 mm in MD and 150 mm in TD, and in the center of the surface thereof on the encapsulant side, a cross mark having a size of 100 mm in MD and 100 mm in TD was drawn with an oily pen. Three samples of the same type were prepared. Next, these were left in a hot air oven at 150°C for 30 minutes, and the degree of shrinkage of the cross mark in the machine direction (MD) was measured relative to the original dimension thereof before shrunk. The data were averaged to give the mean value (%) of the thermal shrinkage rate.

### (4) Storage elastic modulus (E')

Using IT Measurement's viscoelasticity meter, trade name "Viscoelasticity Spectrometer DVA-200", a sample (4 mm in MD, 60 mm in TD) was analyzed in the transverse direction, at an oscillation frequency of 10 Hz, at a strain of 0.1%, at a heating rate of 3°C/min and at a chuck-to-chuck distance of 25 mm, in a range from -150°C to 150°C, and from the found data, the storage elastic modulus (E') (MPa) at 20°C of the sample was obtained.

### (5) Shrinkage stress (σ(A)) of the back sheet (A)

Three samples having a size of 70 mm in MD and 10 mm in TD were cut out of the back sheet (A) to be used, both ends thereof were secured at a chuck-to-chuck distance of 50 mm, the samples were soaked in a silicone bath of the preset lamination temperature for 5 minutes, and the maximum shrinkage stresses generated in the machine direction were measured and averaged to give the mean value (Pa) thereof.

### (6) Shear elastic modulus (G'(B)) of the encapsulant (B)

Using a rheometer (Rheology's trade name "Rheometer MR-300T"), the shear elastic modulus (G') of a sample (thickness: 0.3 mm) placed on a parallel plate of 20-mmϕ was measured under conditions of the oscillation frequency of 1 Hz, the temperature rising rate of 3°C/min and the strain of 0.5%, in a temperature range of 80°C to 200°C, and the value (Pa) at the preset lamination temperature was read.

### (7) Projection index

The ratio (σ(A)/G'(B)) of the values obtained in the above (5) and (6) was calculated.

### (8) Lamination appearance ((i) Projection appearance, (ii) Flatness)

### (i) Projection appearance

Number of projections generated in each of three solar cell modules (n = 1 to 3) was determined. The projection appearance was evaluated under the following criteria. In addition, the mean value of the numbers of the projections used for the evaluation of the three solar cell modules (projection appearance (mean)) was evaluated under the following criteria.
(AA) Projection phenomenon was almost not seen, or only small projections were seen (0 to 3 projections/120 sites).
   (A) Some projection phenomenon was seen, but only small projections were given (4 to 9 projections/120 sites).
   (B) Some projection phenomenon was seen (10 to 19 projections/120 sites)
   (C) Projection phenomenon was significantly seen, and high projections were given (20 projections or more/120 sites).

### (ii) Flatness

In Examples 11 to 17 and Comparative Example 5, the mean state of the appearance between the cells on the surface of the back sheet among the three solar cell modules was evaluated under the following criteria.
(A) Few recesses were seen between the cells, and the flatness of the back sheet surface was good.
(B) Large recesses between the cells were seen, and the entire solar cell module had a grooved chocolate tablet-like appearance.

### [Back Sheet]

Back sheets used in Examples are shown below.
(A-1) : Madico's back sheet, trade name Protekt HD (total thickness: 265 µm, laminate configuration: (encapsulant side) EVA/adhesive layer/PET/coat layer, shrinkage stress (130°C); 2.65 × 10⁵ Pa, shrinkage stress (150°C) ; 4.32 × 10⁵ Pa, thermal shrinkage rate (150°C × 30 min, MD): 1.03%, Tm (EVA layer) : 104°C)
(A-2): A back sheet obtained by using ISOVOLTA's back sheet, trade name Icosolar 2442 (total thickness; 350 µm, laminate comfiguration; (encapsulant side) PVF (white; containing titanium oxide)/adhesive layer/PET/adhesive layer/PVF (white; containing titanium oxide), shrinkage stress (130°C); 2.75 × 10⁵ Pa, shrinkage stress (150°C); 7.36 × 10⁵ Pa, thermal shrinkage rate (150°C × 30 min, MD) ; 0.87%), and subjecting the surface of the encapsulant side of this back sheet to a corona treatment to make the wet index thereof into 60 mN/m or more
(A-3) : TAIFLEX's back sheet, trade name Solmate TPE VEP (total thickness: 283 µm, laminate configuration: (encapsulant side) EVA/adhesive layer/PET/adhesive layer/PVF (white: containing titanium oxide), shrinkage stress (130°C); 0.59 × 10⁵ Pa, shrinkage stress (150°C) ; 1.96 × 10⁵ Pa, thermal shrinkage rate (150°C × 30 min, MD): 0.65%, Tm (EVA layer) : 103°C)
(A-4) : Coveme's back sheet, trade name dyMat PYE (total thickness: 295 µm, laminate configuration: (encapsulant side) EVA/EVA (white: containing titanium oxide)/EVA/adhesive layer/PET/adhesive layer/PET (white: containing barium sulfate), shrinkage stress (130°C); 6.01 × 10⁵ Pa, shrinkage stress (150°C); 8.58 × 10⁵ Pa, thermal shrinkage rate (150°C × 30 min, MD): 1.40%, Tm (EVA layer): 103°C)
(A-5) : A back sheet obtained by subjecting the back sheet (A-2) to a heat treatment to reduce the thermal shrinkage rate (150°C × 30 min, MD) to 0.62% (shrinkage stress (130°C) ; 1.15 × 10⁵ Pa, shrinkage stress (150°C); 3.23 × 10⁵ Pa)
(A-6): A back sheet obtained by integrating the back sheet (A-3) and the encapsulant (B-1) described below by extrusion lamination method (shrinkage stress (130°C); 0.59 × 10⁵ Pa, shrinkage stress (150°C); 1.96 × 10⁵ Pa)
(A-7) : TAIFLEX's back sheet, trade name Solmate TPE BTNE (total thickness: 345 µm, laminate configuration: (encapsulant side) EVA/adhesive layer/PET/adhesive layer/PVF (white: containing titanium oxide), shrinkage stress (130°C) ; 5.3 × 10⁵ Pa, shrinkage stress (150°C); 5.5 × 10⁵ Pa, thermal shrinkage rate (150°C × 30 min, MD): 0.87%, Tm (EVA layer): 109°C)
(A-8): A back sheet obtained by integrating the back sheet (A-1) and the encapsulant (B-4) described below by extrusion lamination method (shrinkage stress (130°C); 2.65 × 10⁵ Pa, shrinkage stress (150°C); 4.32 × 10⁵ Pa)

### [Encapsulant]

The materials to constitute encapsulants are shown below.

### (Olefin-based polymer (X))

(X-1) : Ethylene-octene random copolymer (Dow Chemical's trade name AFFINITY EG8100G, density: 0.870 g/cm³, ethylene/1-octene = 68/32 % by mass (89/11 % by mole), Tm: 59°C, ΔHm: 49 J/g, storage elastic modulus (E') at 20°C: 14 MPa, MFR (temperature: 190°C, load 21.18 N): 1 g/10 min)
(X-2): Ethylene-octene block copolymer (Dow Chemical's trade name Infuse 9000, density: 0.875 g/cm³, ethylene/1-octene = 65/35 % by mass (88/12 % by mole), Tm: 122°C, ΔHm: 44 J/g, storage elastic modulus (E') at 20°C: 27 MPa, MFR (temperature: 190°C, load 21.18 N): 0.5 g/10 min)

### (Olefin-based polymer (Y))

(Y-1): Ethylene-octene random copolymer (Dow Chemical's trade name AFFINITY EG8200G, density: 0.870 g/cm³, ethylene/1-octene = 68/32 % by mass (89/11 % by mole), Tm: 59°C, ΔHm: 49 J/g, storage elastic modulus (E') at 20°C: 14 MPa, MFR (temperature: 190°C, load 21.18 N): 5 g/10 min)
(Y-2) : Ethylene-octene random copolymer (Dow Chemical's trade name ENGAGE 8130, density: 0.864 g/cm³, ethylene/1-octene = 65/35 % by mass (88/12 % by mole), Tm: 49°C, ΔHm: 38 J/g, storage elastic modulus (E') at 20°C: 10 MPa, MFR (temperature: 190°C, load 21.18 N): 13 g/10 min)

### (Silane-modified ethylene-based resin)

(Q-1): Silane-modified ethylene-octene random copolymer (Mitsubishi Chemical's trade name: LINKLON SL800N, density: 0.868 g/cm³, Tm: 54°C and 116°C, ΔHm: 22 J/g and 4 J/g, storage elastic modulus (E') at 20°C: 15 MPa, MFR (temperature: 190°C, load 21.18 N): 1.7 g/10 min)

The encapsulants (B) used in Examples are shown below.
(B-1): As a layer (I), used was a resin composition prepared by mixing 70 parts by mass of the above (X-1) and 30 parts by mass of (Q-1), and as a layer (II), used was a resin composition prepared by mixing 95 parts by mass of (X-1) and 5 parts by mass of (X-2). These were laminated in a mode of coextrusion molding to give a laminate configuration of layer (I)/layer (II)/layer (I), according to a T-die method using a unidirectional double-screw extruder at a resin temperature of from 180 to 200°C, and then rapidly cooled to form a film using a casting emboss roll at 25°C to give an encapsulant having a total thickness of 0.50 mm, in which the thickness of each layer was (I) / (II) / (I) = 0. 05 mm/0.40 mm/0. 05 mm and the storage elastic modulus (E') at 20°C was 15 MPa.
(B-2): An encapsulant having a total thickness of 0.50 mm, in which the thickness of each layer was (I)/(II)/(I) = 0.05 mm/0.40 mm/0.05 mm and the storage elastic modulus (E') at 20°C was 15 MPa, was obtained by the same manner as that for (B-1) above, excepting for changing (X-1) to (Y-1).
(B-3) : As a layer (I), used was a resin composition prepared by mixing 65 parts by mass of the above (X-1), 35 parts by mass of (Y-1) and 15 parts by mass of (Q-1), and as a layer (II), used was a resin composition prepared by mixing 65 parts by mass of (X-1), 35 parts by mass of (Y-1) and 5 parts by mass of (X-2). These were laminated in a mode of coextrusion molding to give a laminate configuration of layer (I)/layer (II)/layer (I), according to a T-die method using a unidirectional double-screw extruder at a resin temperature of from 180 to 200°C, and then rapidly cooled to form a film using a casting emboss roll at 25°C to give an encapsulant having a total thickness of 0.50 mm, in which the thickness of each layer was (I)/(II)/(I) = 0.05 mm/0.40 mm/0.05 mm and the storage elastic modulus (E') at 20°C was 15 MPa.
(B-4): In the same manner as that for (B-3), in which, however, a resin composition prepared by mixing 85 parts by mass of the above (X-1), 15 parts by mass of (Y-2) and 15 parts by mass of (Q-1) was used as the layer (I), and a resin composition prepared by mixing 85 parts by mass of (X-1), 15 parts by mass of (Y-2) and 5 parts by mass of (X-2) was used as the layer (II), an encapsulant having a total thickness of 0. 50 mm was produced, in which the thickness of each layer was (I)/(II)/(I) = 0.05 mm/0.40 mm/0.05 mm and the storage elastic modulus (E') at 20°C was 15 MPa.
(B-5): In the same manner as that for (B-3), in which, however, a resin composition prepared by mixing 60 parts by mass of the above (X-1), 40 parts by mass of (Y-2) and 15 parts by mass of (Q-1) was used as the layer (I), and a resin composition prepared by mixing 60 parts by mass of (X-1), 40 parts by mass of (Y-2) and 5 parts by mass of (X-2) was used as the layer (II), an encapsulant having a total thickness of 0.50 mm was produced, in which the thickness of each layer was (I)/(II)/(I) = 0.05 mm/0.40 mm/0.05 mm and the storage elastic modulus (E') at 20°C was 14 MPa.
(B-6): In the same manner as that for (B-3), in which, however, a resin composition prepared by mixing 100 parts by mass of the above (X-1) and 15 parts by mass of (Q-1) was used as the layer (I) and a resin composition prepared by mixing 100 parts by mass of (X-1) and 5 parts by mass of (X-2) was used as the layer (II), an encapsulant having a total thickness of 0.50 mm was produced, in which the thickness of each layer was (I)/(II)/(I) = 0.05 mm/0.40 mm/0.05 mm and the storage elastic modulus (E') at 20°C was 15 MPa.
(B-7): In the same manner as that for (B-3), in which, however, a resin composition prepared by mixing 100 parts by mass of the above (Y-1) and 15 parts by mass of (Q-1) was used as the layer (I) and a resin composition prepared by mixing 100 parts by mass of (Y-1) and 5 parts by mass of (X-2) was used as the layer (II), an encapsulant having a total thickness of 0.50 mm was produced, in which the thickness of each layer was (I)/(II)/(I) = 0.05 mm/0.40 mm/0.05 mm and the storage elastic modulus (E') at 20°C was 15 MPa.

### (Example 1)

Using a vacuum laminator (NPC's trade name: NLM-230x360) and members shown in Table 1, three solar cell modules were produced under the following conditions, and the lamination appearance was evaluated. The results are shown in Table 1.

### <Configuration>

Glass/encapsulant (B)/cells/encapsulant (B) /back sheet (A)
- Glass: Nakajima Glass Industry's white embossed cover glass for solar cells,
   trade name SOLECT, size 996 mm × 1664 mm, thickness 3.2 mm
- Cell: Q Cell Japan's solar cell unit,
   trade name Q6LTT-200 (6 inches, 2 bus bar-type),
   * Number of cells: 60 (6 lines × 10 cells).
   * When the number of cells is 60, there is a possibility that projections would occur in at most 120 sites.
- Wiring: Hitachi Cable Fine Tech's PV wire
   trade name NoWarp, SSA-SPS 0.2 × 2.0
   (0.2% proof strength, 56 to 57 MPa)
- Back sheet (A):A-1
- Encapsulant (B): B-1
   * The size of the encapsulant (B) was the same as that of the glass (i.e., a size of 996 mm × 1664 mm) <Lamination conditions>
- Preset lamination temperature: 130°C
- Vacuuming time: 5 min
- Press retention time: 5 min
- Pressure condition: 1st (30 kPa), 2nd (60 kPa), 3rd (70 kPa)
- Cooling fan: not used

### (Example 2)

In the same manner as in Example 1 in which, however, the preset lamination temperature was changed from 130°C to 150°C, three solar cell modules were produced and evaluated for the lamination appearance. The results are shown in Table 1.

### (Example 3)

In the same manner as in Example 1 in which, however, the encapsulant (B) used was changed from B-1 to B-2, three solar cell modules were produced and evaluated for the lamination appearance. The results are shown in Table 1.

### (Example 4)

In the same manner as in Example 1 in which, however, the back sheet (A) used was changed from A-1 to A-2, three solar cell modules were produced and evaluated for the lamination appearance. The results are shown in Table 1.

### (Example 5)

In the same manner as in Example 4 in which, however, the preset lamination temperature was changed from 130°C to 150°C, three solar cell modules were produced and evaluated for the lamination appearance. The results are shown in Table 1.

### (Example 6)

In the same manner as in Example 1 in which, however, the back sheet (A) used was changed from A-1 to A-3, three solar cell modules were produced and evaluated for the lamination appearance. The results are shown in Table 1.

### (Example 7)

In the same manner as in Example 6 in which, however, the encapsulant (B) used was changed from B-1 to B-2 and the preset lamination temperature was changed from 130°C to 150°C, three solar cell modules were produced and evaluated for the lamination appearance. The results are shown in Table 1.

### (Example 8)

In the same manner as in Example 1 in which, however, the back sheet (A) used was changed from A-1 to A-4, three solar cell modules were produced and evaluated for the lamination appearance. The results are shown in Table 1.

### (Example 9)

In the same manner as in Example 1 in which, however, the back sheet (A) used was changed from A-1 to A-5, the encapsulant (B) used was changed from B-1 to B-2, and the preset lamination temperature was changed from 130°C to 150°C, three solar cell modules were produced and evaluated for the lamination appearance. The results are shown in Table 1.

### (Example 10)

In the same manner as in Example 1 in which, however, the back sheet (A) used was changed from A-1 to A-6 (back sheet-encapsulant-integrated-sheet), the encapsulant (B) used was changed from B-1 to B-2, and the configuration was changed to glass/encapsulant (B)/cells/back sheet (A) (back sheet-encapsulant-integrated-sheet), three solar cell modules were produced and evaluated for the lamination appearance. The results are shown in Table 1.

### (Comparative Example 1)

In the same manner as in Example 1 in which, however, the encapsulant (B) was changed from B-1 to B-2 and the preset lamination temperature was changed from 130°C to 150°C, three solar cell modules were produced and evaluated for the lamination appearance. The results are shown in Table 1.

### (Comparative Example 2)

In the same manner as in Example 5 in which, however, the encapsulant (B) was changed from B-1 to B-2, three solar cell modules were produced and evaluated for the lamination appearance. The results are shown in Table 1.

### (Comparative Example 3)

In the same manner as in Example 8 in which, however, the encapsulant (B) was changed from B-1 to B-2 and the preset lamination temperature was changed from 130°C to 150°C, three solar cell modules were produced and evaluated for the lamination appearance. The results are shown in Table 1.

### (Comparative Example 4)

In the same manner as in Example 8 in which, however, the encapsulant (B) was changed from B-1 to B-2, three solar cell modules were produced and evaluated for the lamination appearance. The results are shown in Table 1.

### (Example 11)

In the same manner as in Example 1 in which, however, the back sheet (A) used was changed from A-1 to A-3 and the encapsulant (B) used was changed from B-1 to B-3, three solar cell modules were produced and evaluated for the lamination appearance. The results are shown in Table 2.

### (Example 12)

In the same manner as in Example 11 in which, however, the back sheet (A) used was changed from A-3 to A-1 and the encapsulant (B) used was changed from B-3 to B-4, three solar cell modules were produced and evaluated for the lamination appearance. The results are shown in Table 2.

### (Example 13)

In the same manner as in Example 12 in which, however, the back sheet (A) used was changed from A-1 to A-7, three solar cell modules were produced and evaluated for the lamination appearance. The results are shown in Table 2.

### (Example 14)

In the same manner as in Example 13 in which, however, the encapsulant (B) used was changed from B-4 to B-5, three solar cell modules were produced and evaluated for the lamination appearance. The results are shown in Table 2.

### (Example 15)

In the same manner as in Example 12 in which, however, the back sheet (A) used was changed from A-1 to A-8 (back sheet-encapsulant-integrated-sheet), and the configuration was changed to glass/encapsulant (B)/cells/back sheet (A) (back sheet-encapsulant-integrated-sheet), three solar cell modules were produced and evaluated for the lamination appearance. The results are shown in Table 2.

### (Example 16)

In the same manner as in Example 11 in which, however, the encapsulant (B) used was changed from B-3 to B-6, three solar cell modules were produced and evaluated for the lamination appearance. The results are shown in Table 2.

### (Example 17)

In the same manner as in Example 12 in which, however, the encapsulant (B) used was changed from B-4 to B-6, three solar cell modules were produced and evaluated for the lamination appearance. The results are shown in Table 2.

### (Comparative Example 5)

In the same manner as in Example 12 in which, however, the encapsulant (B) was changed from B-4 to B-7 and the preset lamination temperature was changed from 130°C to 150°C, three solar cell modules were produced and evaluated for the lamination appearance. The results are shown in Table 2.

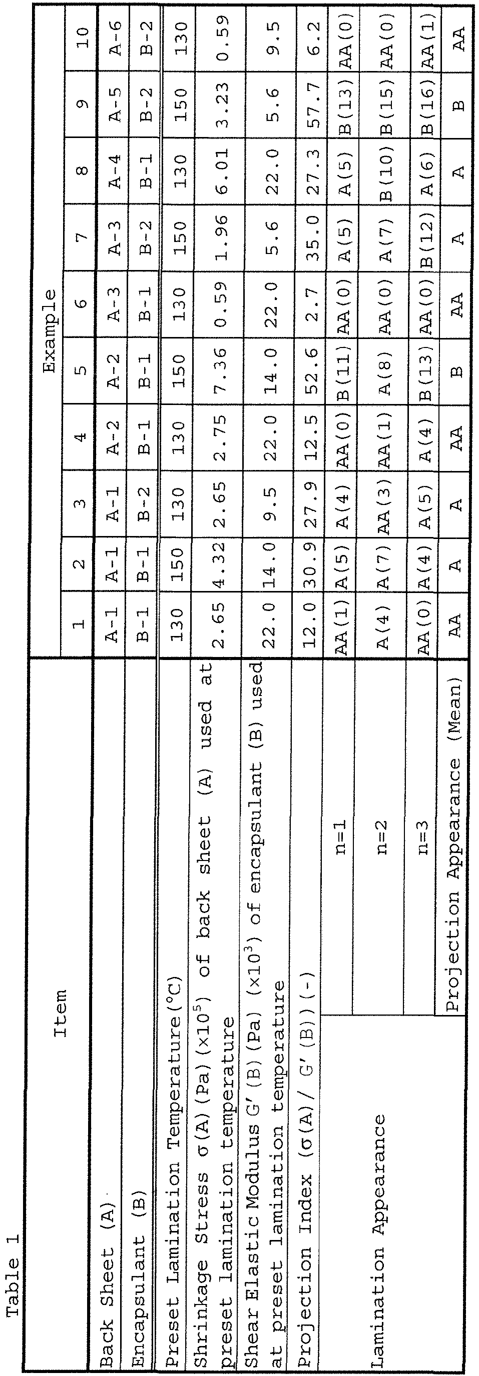

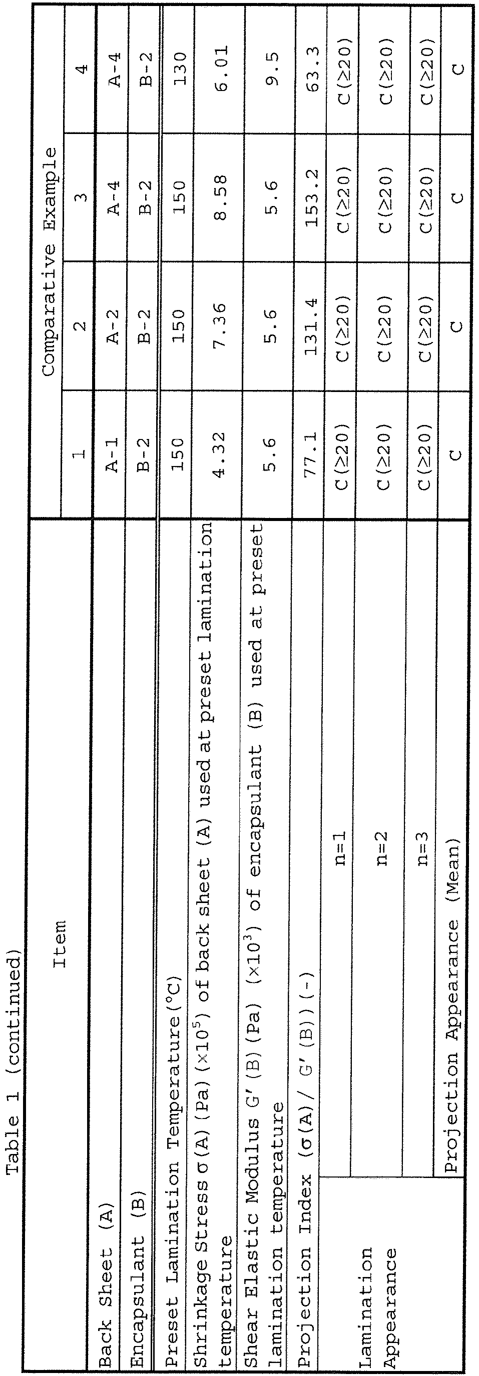

It can be confirmed from Table 1 that, in the case of using a combination of the back sheet and the encapsulant having the projection index defined in the present invention, a solar cell module having a good projection appearance can be obtained (Examples 1 to 10). In particular, it can be confirmed that the combination of the back sheet and the encapsulant having the projection index of 20.0 or less shows a better appearance after lamination (Examples 1, 4, 6 and 10). In contrast, it can be confirmed that, in the case of using a combination of the back sheet and the encapsulant having a projection index exceeding the value defined in the present invention, the projection appearance is deteriorated (Comparative Examples 1 to 4) .
[Table 2]

**Table 2**

| Item | | | Example | | | | | | | Comparative Example |
|---|---|---|---|---|---|---|---|---|---|---|
| | | | 11 | 12 | 13 | 14 | 15 | 16 | 17 | 5 |
| Type of Back Sheet (A) | | | A-3 | A-1 | A-7 | A-7 | A-8 | A-3 | A-1 | A-1 |
| Encapsulant (B) | Type | | B-3 | B-4 | B-4 | B-5 | B-4 | B-6 | B-6 | B-7 |
| | MFR of Olefin-based Polymer (X) (g/10min) | X-1 | 1 | 1 | 1 | 1 | 1 | 1 | 1 | - |
| | | X-2 | 0.5 | 0.5 | 0.5 | 0.5 | 0.5 | 0.5 | 0.5 | 0.5 |
| | MFR of Olefin-based Polymer (Y) (g/10min) | Y-1 | 5 | - | - | - | - | - | - | 5 |
| | | Y-2 | - | 13 | 13 | 13 | 13 | - | - | - |
| Preset Lamination Temperature (°C) | | | 130 | 130 | 130 | 130 | 130 | 130 | 130 | 150 |
| Shrinkage Stress σ(A) (Pa) (×10⁵) of back sheet (A) used at preset lamination temperature | | | 0.59 | 2.65 | 5.3 | 5.3 | 2.65 | 0.59 | 2.65 | 4.32 |
| Shear Elastic Modulus G' (B) (Pa) (×10³) of encapsulant (B) used at preset lamination temperature | | | 17.6 | 18.3 | 18.3 | 13.7 | 18.3 | 21.5 | 21.5 | 5.3 |
| Projection Index (σ(A)/ G'(B))(-) | | | 3.4 | 14.4 | 29.0 | 38.7 | 14.4 | 2.7 | 12.3 | 81.5 |
| Lamination Appearance | Projection Appearance | n=1 | AA(0) | AA(1) | A(6) | B (13) | AA(0) | AA(0) | AA(1) | C(≥20) |
| | | n=2 | AA(0) | AA(0) | A(7) | B(11) | AA(0) | AA(0) | AA(1) | C(≥20) |
| | | n=3 | AA(0) | AA(1) | A(5) | B(11) | AA(0) | AA(1) | AA(1) | C(≥20) |
| | | Projection Appearance (Mean) | AA | AA | A | B | AA | AA | AA | C |
| | Flatness | | A | A | A | A | A | B | B | A |

It can be confirmed from Table 2 that a solar cell module produced using an encapsulant additionally satisfying the Requirement (P) defined above shows enhanced flatness as well as good projection appearance. In particular, it can be confirmed that a solar cell module produced using an encapsulant having a projection index of 20.0 or less and additionally satisfying the Requirement (P) defined above shows better performances both in the projection appearance and the flatness (Examples 11, 12 and 15).

### [Industrial Applicability]

According to the present invention, with respect to a solar cell module, there are provided a solar cell module having a good appearance after lamination, a back sheet-encapsulant-integrated-sheet, and a method for producing the solar cell module.

It is possible to predict the final appearance prior to actual lamination of solar cell modules by measuring basic physical properties, such as shrinkage stress of the back sheet and shear elastic modulus of the encapsulant at the preset lamination temperature. In addition, since the lamination condition can be set efficiently, the time to be taken for condition investigation and the cost for various members can be reduced, and, as a result, the production cost of solar cell modules can be expected to be greatly reduced.

### [Reference Signs List]

- 10: Transparent Substrate
- 12A, 12B: Encapsulant Resin Layer
- 14A, 14B: Solar Cell Element
- 16: Back Sheet
- 18: Junction Box
- 20: Wiring

## Claims

1. A solar cell module comprising at least a back sheet (A) and an encapsulant (B) laminated, wherein the ratio (σ(A)/G'(B)) of a shrinkage stress (σ(A)) (Pa) of the back sheet (A) and a shear elastic modulus (G' (B)) (Pa) of the encapsulant (B) at a preset lamination temperature is 60.0 or less,
the shrinkage stress (σ(A)) of the back sheet (A) being a measured value (Pa) for the back sheet (A) at the preset lamination temperature; and
the shear elastic modulus (G' (B)) of the encapsulant (B) being a measured value (Pa) for the encapsulant (B) at an oscillation frequency of 1Hz at the preset lamination temperature.

2. The solar cell module according to claim 1, wherein the ratio ((σ(A)/G'(B)) of the shrinkage stress (σ(A)) (Pa) of the back sheet (A) and the shear elastic modulus (G'(B)) (Pa) of the encapsulant (B) at the preset lamination temperature is 0.01 or more and 60.0 or less.

3. The solar cell module according to claim 1, wherein the ratio (σ(A)/G'(B)) of the shrinkage stress (σ(A))(Pa) of the back sheet (A) and the shear elastic modulus (G'(B)) (Pa) of the encapsulant (B) at the preset lamination temperature is 0.01 or more and 35.0 or less.

4. The solar cell module according to claim 1, wherein the ratio ((σ(A)/G'(B)) of the shrinkage stress (σ(A)) (Pa) of the back sheet (A) and the shear elastic modulus (G'(B)) (Pa) of the encapsulant (B) at the preset lamination temperature is 1.0 or more and 20.0 or less.

5. The solar cell module according to any one of claims 1 to 4, wherein the storage elastic modulus (E') of the encapsulant (B) at an oscillation frequency of 10 Hz and at a temperature of 20°C is 1 to 100 MPa.

6. The solar cell module according to any one of claims 1 to 5, wherein the encapsulant (B) is an encapsulant comprising, as a main ingredient, a copolymer of ethylene and an α-olefin having 3 to 20 carbon atoms.

7. The solar cell module according to any one of claims 1 to 6, wherein the encapsulant (B) is used on the inner side of the back sheet (A).

8. The solar cell module according to claim 7, wherein the encapsulant (B) further satisfies the following Requirement (P) :
Requirement (P); a resin composition to constitute the encapsulant (B) comprises an olefin-based polymer (X) having an MFR (JIS K7210, temperature: 190°C, load: 21.18 N) of less than 5 g/10 min and an olefin-based polymer (Y) having an MFR (JIS K7210, temperature: 190°C, load: 21.18 N) of 5 g/10 min or more.

9. The solar cell module according to claim 8, wherein the mixing ratio by mass of the olefin-based polymer (X) and the olefin-based polymer (Y) contained in the resin composition to constitute the encapsulant (B) is (95 to 55)/(5 to 45).

10. The solar cell module according to claims 8 or 9, wherein the MFR (JIS K7210, temperature: 190°C, load: 21.18 N) of the olefin-based polymer (X) contained in the resin composition to constitute the encapsulant (B) is 0.5 g/10 min or more and less than 5 g/10 min, and the MFR (JIS K7210, temperature: 190°C, load: 21.18 N) of the olefin-based polymer (Y) is 5 g/10 min or more and 100 g/10 min or less.

11. The solar cell module according to any one of claims 1 to 10, wherein the encapsulant (B) has a laminate configuration that comprises at least a soft layer of which the storage elastic modulus (E') in dynamic viscoelastometry at an oscillation frequency of 10 Hz and at a temperature of 20°C is less than 100 MPa, and a hard layer of which the storage elastic modulus (E') in dynamic viscoelastometry at an oscillation frequency of 10 Hz and at a temperature of 20°C is 100 MPa or more.

12. The solar cell module according to any one of claims 1 to 11, wherein the encapsulant (B) is an encapsulant that is not substantially crosslinked.

13. The solar cell module according to any one of claims 1 to 12, wherein the shrinkage stress (σ(A)) of the back sheet (A) is 7 × 10⁵ Pa or less at 130°C and at 150°C.

14. The solar cell module according to any one of claims 1 to 12, wherein the shrinkage stress (σ(A)) of the back sheet (A) is 4 × 10⁵ Pa or less at 130°C and at 150°C.

15. The solar cell module according to any one of claims 1 to 14, wherein the back sheet (A) and the encapsulant (B) are integrated together.

16. A method for manufacturing the solar cell module according to any one of claims 1 to 15, wherein the preset lamination temperature is 100°C or higher and 135°C or lower.

17. A back sheet-encapsulant-integrated-sheet for a solar cell module, comprising at least a back sheet (A) and an encapsulant (B), wherein the ratio (σ(A)/G'(B)) of a shrinkage stress (σ(A)) (Pa) of the back sheet (A) and a shear elastic modulus (G'(B)(Pa) of the encapsulant (B) at a preset lamination temperature is 60.0 or less,
the shrinkage stress (σ(A)) of the back sheet (A) being a measured value (Pa) for the back sheet (A) at the preset lamination temperature; and
the shear elastic modulus (G' (B)) of the encapsulant (B) being a measured value (Pa) for the encapsulant (B) at an oscillation frequency of 1Hz at the preset lamination temperature.

18. The back sheet-encapsulant-integrated-sheet for a solar cell module according to claim 17, wherein the encapsulant (B) satisfies the following Requirement (P):
Requirement (P); a resin composition to constitute the encapsulant (B) comprises an olefin-based polymer (X) having an MFR (JIS K7210, temperature: 190°C, load: 21.18 N) of less than 5 g/10 min and an olefin-based polymer (Y) having an MFR (JIS K7210, temperature: 190°C, load: 21.18 N) of 5 g/10 min or more.
